(19) **Europäisches Patentamt European Patent Office Office européen des brevets**

(11) **EP 1 512 983 B1**

(12) **EUROPÄISCHE PATENTSCHRIFT**

(45) Veröffentlichungstag und Bekanntmachung des Hinweises auf die Patenterteilung:
**20.10.2010 Patentblatt 2010/42**

(51) Int Cl.:
***G01R 33/34*** *(2006.01)*

(21) Anmeldenummer: **04020216.0**

(22) Anmeldetag: **26.08.2004**

(54) **NMR-Kryokopf mit getrennten Wärmetauschern für die Kühlung der Detektions-Spulen und der Sende bzw. Entkopplungs-Spulen**

NMR-coldhead with separate heat exchangers for cooling of the detection and of the emission or decoupling coils

Tête RMN réfrigérée avec des échangeurs de chaleur séparés pour le refroidissement des bobines de détection et d'émission ou de découplage

(84) Benannte Vertragsstaaten:
**CH DE FR GB LI**

(30) Priorität: **02.09.2003 DE 10340352**

(43) Veröffentlichungstag der Anmeldung:
**09.03.2005 Patentblatt 2005/10**

(73) Patentinhaber: **Bruker BioSpin AG
8117 Fällanden (CH)**

(72) Erfinder: **Marek, Daniel Dr.
5103 Möriken (CH)**

(74) Vertreter: **Kohler Schmid Möbus
Patentanwälte
Ruppmannstraße 27
70565 Stuttgart (DE)**

(56) Entgegenhaltungen:
**EP-A- 0 878 718    EP-A- 1 089 086
US-A- 5 508 613**

• **PATENT ABSTRACTS OF JAPAN Bd. 2000, Nr. 07, 29. September 2000 (2000-09-29) & JP 2000 105072 A (JAPAN SCIENCE & TECHNOLOGY CORP), 11. April 2000 (2000-04-11)**

## Beschreibung

Die Erfindung betrifft einen Kryokopf für Kernspinresonanz(=NMR)-Messungen, mit mindestens einem Detektionskanal zum Empfang von NMR-Signalen und mit mindestens einem Sende- oder Entkopplungskanal, wobei für die verschiedenen Kanäle verschiedene Hochfrequenz(=HF)-Spulen oder Resonatoren vorgesehen sind, wobei der Kryokopf einen Wärmetauscher aufweist, der durch ein durchströmendes Fluidum, insbesondere Helium, kühlbar ist, und wobei die HF-Spulen oder Resonatoren sowohl mindestens eines Detektionskanals als auch mindestens eines Sende- oder Entkopplungskanals auf kryogene Temperaturen kühlbar sind.

Ein solcher Kryokopf ist aus der US 5,889,456 bekannt.

## Hintergrund der Erfindung

Bei einer Anordnung zur Messung mit Hilfe der Kernspinresonanz befindet sich im starken stationären Magnetfeld eines typischerweise supraleitenden Magneten ein sogenannter Probenkopf. In diesen wird die zu messende Probe eingeführt. Der Probenkopf beinhaltet Hochfrequenz(=HF)-Spulen bzw. Resonatoren, die einerseits zur Anregung der Kernspins dienen wie auch die von den angeregten Kernspins erzeugten Signale empfangen. Da die Kernspinsignale i.A. sehr schwach sind, ist das Signal- zu Rauschverhältnis (S/N) bei der Kernspinresonanz immer ein sehr wichtiges, wenn nicht wichtigstes Leistungskriterium. Eine sehr effiziente Möglichkeit, dieses S/N Verhältnis zu verbessern, ist es, die Empfangsspule auf möglichst tiefe Temperaturen abzukühlen. Dadurch steigt die Effizienz, und gleichzeitig wird das thermische Rauschen minimiert. Solche Probenköpfe nennen wir Kryoköpfe. Die vorliegende Erfindung behandelt einen Aspekt der Kühlung der Empfangsspule mit dem Zweck, diese Temperatur auch bei gleichzeitiger Hochfrequenz-Einstrahlung auf einem anderen Kern möglichst tief und stabil zu halten, um eine unnötige Verschlechterung des S/N Verhältnisses wie allfällige weitere Artefakte zu minimieren.

Bei den meisten Typen von Kryoköpfen beinhaltet der Kopf einen Detektionskanal (z.B. 1 H (Protonen)), sowie einen oder mehrere sogenannte Entkopplungskanäle (z.B. 13C und 15N (Isotope von Kohlenstoff bzw. Stickstoff)). Zusätzlich enthält er normalerweise einen Lockkanal zur Stabilisierung des Magnetfeldes, der Deuterium verwendet (2H). Ein solcher Kopf wird ein Triple-Resonanz-Invers Kopf (TXI) genannt.

In der Folge wollen wir in der untenstehenden Ausführung einen solchen Kopf explizit behandeln, wobei dies aber nicht als eine abschließende Beschränkung, sondern nur als ein mögliches Beispiel für die erfindungsgemäße Lehre betrachtet werden darf. Beliebige andere Kombinationen von Detektions- und Entkopplungskernen sind möglich. Insbesondere ist es auch möglich, dass derselbe Kern mit zwei Kanälen und somit auch zwei HF Spulen betrieben wird, ein Kanal zum Senden, und der andere zum Empfangen, auf derselben Frequenz.

Bei einem TXI Kopf ist es wichtig, dass die Empfindlichkeit auf dem Detektionskanal (1 H) maximiert wird. Im normalen Betriebsfall werden die Entkopplungskerne (13C und 15N) nur zur Entkopplung sowie zum Magnetisierungstransfer verwendet. Ein solcher Kopf besitzt typischerweise zwei HF Spulen. Eine innere, auf der der Detektionskanal angeordnet ist, und eine zweite, herumliegende äußere, auf der die X Kanäle (13C und 15N) angeordnet sind. Der Lockkern kann entweder auf der inneren oder auch der äußeren Spule mit geschaltet sein.

## Stand der Technik

Bei den nach dem Stand der Technik gebauten Probenköpfen wird die Empfindlichkeit (d.h. das Signal) optimiert, indem die Detektionsspule möglichst nahe an der Probe angeordnet wird, d.h. zuinnerst um die Probe herum. Bei den Kryoköpfen wird ein zweiter Punkt zusätzlich optimiert, indem die HF-Spulen auf tiefe Temperaturen gekühlt werden, typischerweise <25K. Zusätzlich wird typischerweise auch der Vorverstärker gekühlt, damit sein Rauschbeitrag nicht überproportional groß im Vergleich zum dann sehr geringen thermischen Rauschen der Empfangsspule wird. Dieser kann z. B. auf 77K oder auch auf einer tieferen Temperatur betrieben werden.

Bei einem Kryokopf wird die Kälte dem Spulensystem typischerweise mittels eines kalten, gasförmigen He-Kreislaufs zugeführt (bzw. die Wärme abgeführt). Eine in der Praxis günstige Ausführung ist die Verwendung eines Gifford-McMahon Cryocoolers, der diesen kalten He-Kreislauf kühlt. Üblicherweise sind solche Cooler zweistufig ausgeführt, um die erforderlichen tiefen Temperaturen zu erreichen.

Damit das Rauschen nicht durch den Vorverstärker unnötig erhöht wird, ist es vorteilhaft und entspricht dem Stand der Technik, dass der Vorverstärker ebenfalls gekühlt wird. Es ist des weiteren vorteilhaft und entspricht dem Stand der Technik, dass der Vorverstärker mit in den Kryokopf eingebaut wird, um S/N Verluste durch Führung von Signalleitungen zwischen der HF Spule und dem Vorverstärker zu minimieren. Der Vorverstärker wird nach dem Stand der Technik ebenfalls vom Cryocooler gekühlt.

Eine besonders günstige Ausführung, die viel Flexibilität zulässt, ist im Patent US 5,889,456 beschrieben (Fig. 3a in US 5,889,456). Dies ist hier schematisch in Fig. 2 dargestellt. Die Kühlleistung eines zweistufigen Gifford-McMahon Coolers (Coldheads) 6 wird dabei an den beiden Stufen 7 und 8 abgegriffen, und dem Kryokopf 1 werden zwei Kältesenken (Wärmetauscher) 38 und 39 zur Verfügung gestellt, mit verschiedenen Temperaturen. Die Kälte wird vom Kühlsystem 5 zum Kryokopf 1 typischerweise mittels gasförmigem Helium transportiert, das durch die beiden Kühlschlaufen 9 und 10 zirkuliert.

Die wärmere Temperatur [ca. 77K] wird nach dem Stand der Technik mittels des wärmeren Kreislaufs 9 zur Kühlung von Vorverstärkern sowie strukturellen Elementen im Kryokopf verwendet, was die erforderliche Kühlleistung für den kalten Kreislauf sparen hilft. Dies ist insbesondere möglich, da an der wärmeren Stufe 7 des Coldheads 6 wesentlich mehr Kühlleistung anfällt als an der kälteren Stufe 8. Der kalte Kreislauf 10 [<25K] wird dann verwendet, um die HF-Spulenanordnung mit möglichst geringen Wärmeleistungs- und Temperaturverlusten zu kühlen.

Die zu messende Probe 2 befindet sich in einem für die Hochfrequenzfelder durchlässigen sogenannten Zentralrohr 22, das durch den Kryokopf hindurch geht. Dieses Rohr wie auch die Probe 2 befinden sich ungefähr auf Raumtemperatur. Die Detektionsspule 11 wie auch die Entkopplungsspule 12 werden mittels des Wärmetauschers 13 auf die Arbeitstemperatur (<25K) gekühlt. Im Inneren des Kryokopfes befindet sich Vakuum 3, das die nötige thermische Isolation der kalten Teile gegenüber dem Zentralrohr und somit der Probe wie auch gegenüber den Außenflächen des Kryokopfes gewährleistet.

Der Vorverstärker 4 wird ebenfalls gekühlt. Die Kühlung des Spulen-Wärmetauschers 13 geschieht mittels der Kühlschlaufe 10 ("Kalte Kühlschlaufe"), und die Kühlung des Vorverstärkers auf typischerweise 77K mittels der Kühlschlaufe 9 ("Warme Kühlschlaufe").

Die Kälte wird im Kühlsystem 5 erzeugt. Dieses ist mit dem Kryokopf mittels der ebenfalls evakuierten Transferleitung 40 verbunden. Die Kälte im Kühlsystem 5 wird im Coldhead 6 produziert. Dieser besitzt typischerweise zwei Stufen, die erste Stufe 7 mit einer Temperatur von ca. 40-77K, und die zweite Stufe 8 mit einer Temperatur <25K. Das Kühlmedium, hier He-Gas, wird durch einen bei Raumtemperatur betriebenen Kompressor (nicht dargestellt) angetrieben, der mit dem Kühlsystem mittels der Anschlüsse 41 verbunden ist. Das zunächst bei Raumtemperatur befindliche He-Gas wird mittels des Gegenstrom-Wärmetauschers 32 vorgekühlt, dann mit dem Stufen-Wärmetauscher 38 der ersten Coldheadstufe 7 weiter gekühlt. Dann geht es durch den zweiten Gegenstrom - Wärmetauscher 33, wo es weiter vorgekühlt wird, zum Stufen-Wärmetauscher 39 der zweiten Coldhead-Stufe 8.

Hier ist die minimale Temperatur erreicht. Dann geht das He in den Kryokopf, wo der Wärmetauscher 13 wie oben beschrieben gekühlt wird. Nachdem das He zurück im Kühlsystem ist, geht es über den Gegenstrom-Wärmetauscher 33 und dann mittels der Kühlschlaufe 9 zum Kopf, wo es die Elektronik kühlt. Nachdem es wieder zurück im Kühlsystem 5 ist, gibt es seine Kälte am Gegenstrom-Wärmetauscher 32 an das eintretende Gas wieder ab und verlässt beim Anschluss 41 wiederum auf Raumtemperatur den Cooler, um im Kompressor wieder weiterbefördert zu werden.

Das Drosselventil 34 bildet einen Bypass zur gegebenenfalls notwendigen Regulierung der Kühlleistung der Kühlschlaufe 9.

Eine genaue thermische Analyse eines solchen Systems findet sich in US 5,889,456. Eine solche Anordnung funktioniert einwandfrei, geht mit der Kühlleistung haushälterisch um und ist auch sehr robust und anspruchslos, was die erforderliche thermische Auslegung betrifft.

Es ist aber auch möglich, mit nur einem Kreislauf sowohl die HF Spulen zu kühlen wie auch den oder die Vorverstärker. Die Details der Kühlung der Vorverstärker-Elektronik sind aber für die vorliegende Erfindung nicht von primärer Relevanz und sollen hier nicht weiter erörtert werden.

**Problemstellung**

Die Nachteile der Systeme nach dem Stand der Technik sind die folgenden:

Es bildet sich ein inhärenter Widerspruch zwischen den Funktionen der beiden Spulen:

1. Die Detektionsspule 11 sollte stets bei möglichst tiefer Temperatur arbeiten, damit das thermische Rauschen auf einem Minimum bleibt.

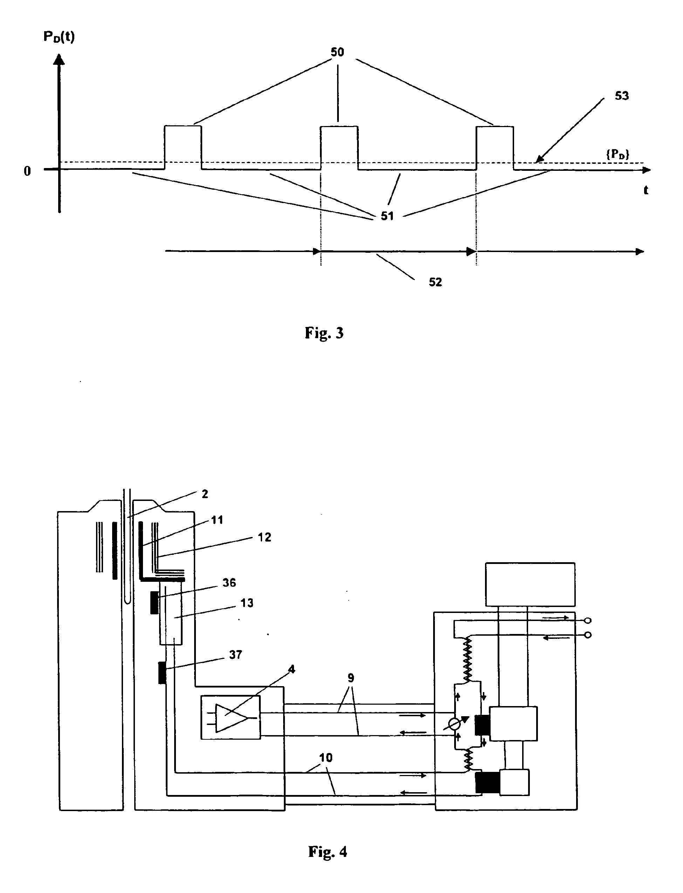

2. Die Entkopplungsspule 12 erzeugt hohe HF-Felder. Somit ist sie hohen HF-Leistungen ausgesetzt. Diese werden zum größten Teil in der Spule selbst dissipiert, und somit ist sie hohen thermischen Leistungen ausgesetzt. Bei einer Entkopplung werden während längerer Zeit Leistungen von der Größenordnung 10 W dissipiert. Diese Leistungen bilden die Haupt-Wärmelast des Kryokopfes, währenddem die Detektionsspule (abgesehen von vergleichsweise sehr geringen Strahlungsverlusten zur Probe hin) in den meisten Fällen praktisch keine oder nur vergleichsweise sehr geringe Kühlleistung benötigt. Typischerweise werden die Entkopplungs-Leistungen $P_D(t)$ pulsweise angelegt (siehe **Fig. 3).** (Die einzelnen Leistungspulse 50 können entweder aus einer kontinuierlichen Leistung (CW) bestehen, oder aber ihrerseits eine weitere innere Struktur haben, d.h. aus einer Reihe von aneinandergereihten Pulsen bestehen (z.B. CPD = Composite Pulse Decoupling). Dies ist aber für die vorliegenden Betrachtungen nicht von Belang. Wichtig ist nur, dass während der Zeitdauer 50 eine hohe Leistung dissipiert wird.) In diesen Ausführungen wollen wir mit einem einfachen Beispiel, das aber keinesfalls abschließend sein soll, arbeiten. Demnach wird während der Zeitabschnitte 50 mit der Dauer von 200msec entkoppelt, d.h. eine HF-Leistung auf die Entkopplungs-Spule angewandt, und dann wird während der Pause 51 von 0.8 sec gewartet, bis das Spinsystem wieder relaxiert hat. Dies ergibt eine Repetitionsperiode 52 von 1 sec und einen Duty-Cycle D von 0.2 oder 20%. Es sind aber auch sehr viele andere Pulssequenzen in Verwendung. Insbesondere kann der Duty-Cycle auch wesentlich höher werden.

Die Detektionsspule sollte möglichst während des ganzen Experiments auf einer konstanten Temperatur arbeiten, damit sich einerseits keine Rauschänderungen bzw. -erhöhungen im Betrieb ergeben. Andererseits ist es auch möglich, dass die Eigenresonanz der Spule in einem gewissen Maß temperaturabhängig ist. Somit können sich bei einem gepulsten Betrieb der Entkopplung Frequenzänderungen der Spule ergeben, was zu störenden Phasenmodulations-Artefakten in den erhaltenen Spektren führen kann.

Nach dem Stand der Technik wird die Detektionsspule 11 thermisch vom gleichen Wärmetauscher 13 wie die Entkopplungs-Spule 12 gekühlt. Um Schwankungen der Spulentemperatur zu verhindern, wird nach dem Stand der Technik die Temperatur des Wärmetauschers 13 mit einer aktiven Regelung, bestehend aus einem Temperatursensor 36 und einem Heizer 37 mittels eines Regelsystems (nicht dargestellt) konstant gehalten (Fig. 4).

Dies funktioniert auf den ersten Blick zufriedenstellend, hat aber bei einer genauen Analyse eine Reihe von Nachteilen, die sich aus den folgenden Begebenheiten ergeben:

1. Ineffizienz des Wärmetauschers 13.
2. Beschränkte Wärmetransportkapazität des He-Gases.
3. Die Temperaturregelung ist nur statisch (Mittelwert) und i.A. nicht in der Lage, dynamisch zu regeln.
4. Eine dynamische Regelung wäre auch nur beschränkt sinnvoll, da dann auf die maximal auftretende, sehr hohe Temperatur geregelt werden müsste.
5. Es ist sehr schwierig, die wahre Temperatur der HF-Spule selbst zu messen und folglich auch zu regeln, insbesondere in der Gegenwart von starken zeitlichen Schwankungen.

Wir wollen in der Folge auf die obigen Punkte eingehen.

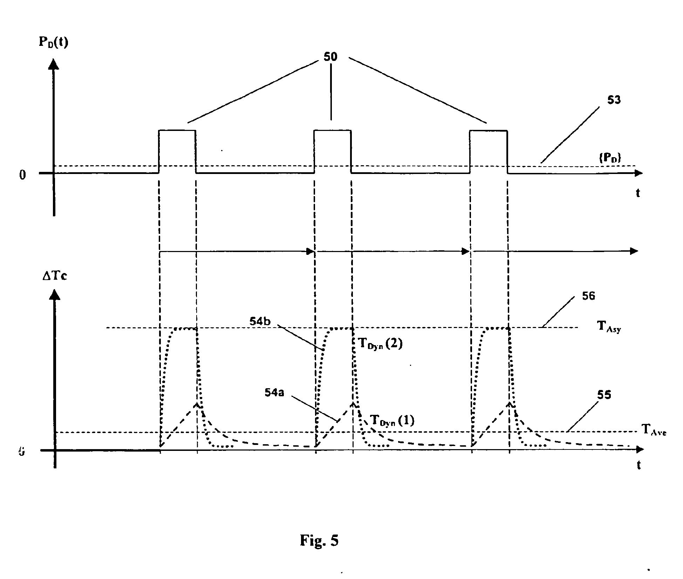

Obwohl die Regelung einen konstanten Temperatur-Wert anzeigen mag, ist der wahre Temperaturverlauf der HF Spulen nicht so einfach. Dies wird in Fig. 5 für eine Anordnung gemäß dem Stand der Technik dargestellt.

Dabei ist in der oberen Darstellung von Fig. 5 der zeitliche Verlauf der Entkopplungsleistung $P_D(t)$ als Funktion der Zeit dargestellt. In der unteren Darstellung ist die Temperaturerhöhung beider HF Spulen $\Delta T_c$ (gegenüber dem Fall ohne Entkopplung) dargestellt.

Auf jeden Fall resultiert die mittlere Leistung $\{P_D\}$ in einer Temperaturerhöhung der mittleren Temperatur. Dies ist mit $T_{Ave}$ dargestellt.

Dies ergibt eine gewisse mittlere Temperatur $T_{Ave}$. Wird der Regelpunkt der Regelung auf diese oder eine höhere Temperatur gesetzt, so kann der Kopf ohne wie auch mit Entkopplung auf dieser Temperatur konstant gehalten werden.

Dies ist jedoch nicht der ganze Tatverhalt. Wird der Temperaturverlauf zeitaufgelöst dynamisch betrachtet, so ergibt sich ein Bild, das mit den gestrichelten Linien $T_{Dyn}$ dargestellt wird.

Hier ist zu bemerken, dass wegen der sehr schnellen Erwärmung das Regelsystem nicht in der Lage ist, während dieser Zeit nachzuregeln. Auch wenn es das könnte, würde dadurch nur die Variation der Temperatur behoben. Dazu müsste aber der Setpoint auf die extrem hohe asymptotische Temperatur $T_{Asy}$ gesetzt werden, was keinerlei Verbesserung der absoluten (maximalen) Temperatur bedeuten würde (siehe weiter unten).

Während des Pulses erwärmt sich die Spulenbaugruppe und der Wärmetauscher 13 sehr stark, da während dieser Zeit eine sehr hohe Leistung anliegt, die die mittlere (CW) Leistung bei weitem übersteigt (Faktor 1/D).

Somit ergibt sich, wie in **Fig. 5** unten dargestellt, beim Einsetzen der Pulsleistung auf dem Entkopplungskanal zunächst eine starke Temperaturzunahme, deren Steigung durch die spezifische Wärme des Wärmetauschers und der Spulenanordnung gegeben ist. Bei einer hohen spezifischen Wärme C der Spulenbaugruppe und des Wärmetauschers 13 ist die Erwärmung moderat, bevor die Abkühlphase wieder einsetzt. Dies ist durch $T_{Dyn}(1)$ dargestellt.

Bei einem kleinen C steigt die Temperatur jedoch rapide an. Dies ist durch $T_{Dyn}(2)$ dargestellt. Die Temperatur erreicht bereits innerhalb der Entkopplungsdauer die maximale asymptotische Temperatur $T_{Asy}$ und stabilisiert sich dort mehr oder weniger. Dieser Wert liegt wesentlich über der mittleren Temperatur $T_{Ave}$ (wegen Faktor 1/D).

Das Ungünstige dabei ist jedoch, dass gerade während dieser Zeit 50 die Akquisition (Datenaufnahme) auf dem Empfangskanal stattfindet, also gerade dort, wo das Rauschen der Detektionsspule und somit auch ihre Temperatur minimal sein sollte.

Die spezifische Wärme nimmt bei den üblicherweise für die Wärmetauscher verwendeten Materialien (Metallen) im betrachteten Temperaturbereich mit abnehmender Temperatur sehr stark ab. Dies hat zur Folge, dass bei Systemen, die mit tiefen Temperaturen arbeiten, diese spezifische Wärme C immer kleiner wird, und somit der extrem hohe $T_{Asy}$

innerhalb des Entkopplungspulses immer mehr erreicht wird.

Neben der wesentlich höheren Temperatur während der Akquisition, die die mittlere und angezeigte Temperatur bei weitem übersteigen kann, kommt noch der Faktor dazu, dass sich die Temperatur der Empfangsspule gerade dann sehr massiv ändert, währenddem sie ihren Dienst tut. Hier können sich sowohl Abstimmfehler wie auch Phasenänderungen während der Akquisition ergeben, die sehr hässliche und nicht-korrigierbare Phasenfehler in den Spektren erzeugen können.

Wie man sieht, sind nach dem Stand der Technik die thermischen Verhältnisse der Detektionsspule im Gegensatz zu der schönen und konstanten mittleren Regeltemperatur, die das Regelsystem vortäuscht, alles andere als ideal. Insbesondere kann die tatsächliche Temperatur der Detektionsspule sehr wesentlich über der vermeintlichen liegen und somit die tatsächlich mögliche Performance und spektrale Qualität vermindern.

Aufgabe der vorliegenden Erfindung ist es, die obigen Nachteile des Standes der Technik zu vermeiden, insbesondere eine minimale und konstante absolute Temperatur an der Empfangsspule zu gewährleisten.

## Kurze Beschreibung der Erfindung

Diese Aufgabe wird durch einen Kryokopf der eingangs vorgestellten Art dadurch gelöst, dass mindestens zwei Wärmetauscher vorgesehen sind, wobei mindestens ein erster Wärmetauscher die HF-Spule oder den Resonator des mindestens einen Detektionskanals und mindestens ein weiterer Wärmetauscher die HF-Spule oder den Resonator des mindestens einen Sende- oder Entkopplungskanals kühlt, und wobei der mindestens eine erste Wärmetauscher von dem mindestens einen weiteren Wärmetauscher getrennt ist.

Die oben genannten, subtilen, aber sehr schwerwiegenden Nachteile können erfindungsgemäß behoben werden, wenn die Kühlung der Detektions- und Entkopplungsspulen mehr oder minder vollständig entkoppelt wird. Die Kühlungsentkopplung erfolgt erfindungsgemäß durch mindestens zwei voneinander räumlich getrennte Wärmetauscher, nämlich den mindestens einen ersten Wärmetauscher und den mindestens einen weiteren (zweiten) Wärmetauscher. Die zur Verfügung stehende gesamte Kühlleistung wird gezielt auf die HF-Spulen oder Resonatoren der einzelnen Kanäle verteilt. Insbesondere kann erfindungsgemäß an der oder den HF-Spulen oder Resonatoren des mindestens einen Detektionskanals eine tiefere und besser konstant zu haltende Temperatur eingestellt werden als an der oder den HF-Spulen oder Resonatoren des mindestens einen Sende- oder Entkopplungskanals, wo eine hohe gepulste HF-Leistung anfällt. Temperaturschwankungen im Bereich der Sende- oder Entkopplungsspulen schlagen nicht mehr auf die Temperatur der Empfangsspule durch. Dadurch wird die Qualität der detektierten NMR-Signale deutlich verbessert.

Der Probenkopf wird statt mit einem erfindungsgemäß mit zwei oder mehreren separaten Wärmetauschern ausgerüstet, die thermisch voneinander möglichst entkoppelt sind. Währenddem der eine Wärmetauscher die Detektionsspule kühlt, wird die Entkopplungsspule mit einem separaten Wärmetauscher gekühlt. In der konkreten Ausführung sind verschiedene, insbesondere die unten aufgeführten Ausführungsvarianten möglich.

Bevorzugt ist eine Ausführungsform des erfindungsgemäßen Kryokopfs, bei der der oder die Wärmetauscher des mindestens einen Detektionskanals durch eine separate Kühlschlaufe des Fluidums kühlbar sind, die von einer Kühlschlaufe des einen oder der mehreren Wärmetauscher des mindestens einen Sende- oder Entkopplungskanals getrennt ist. Erster und weiterer Wärmetauscher sind dann bezüglich des Fluidums vollständig entkoppelt und können mit jeweils angepasster Kühlleistung betrieben werden.

Separate Kühlschlaufen zeichnen sich dadurch aus, dass sie am Probenkopf (Kryokopf) jeweils eigene Zu- und Ableitungen für das Fluidum (Kühlmittel) besitzen. Dadurch können jeweils separate absolute Temperaturen in den einzelnen Kühlschlaufen über das jeweils zugeführte Fluidum eingestellt werden. Insbesondere können für beide Kühlschlaufen auch separate, völlig unabhängige Kühlmittelkreisläufe außerhalb des Probenkopfes vorgesehen sein. Dabei können sogar auch zwei separate Kühler (Coldheads) für die beiden Kreisläufe verwendet werden. In den meisten Fällen wird jedoch ein einziger Coldhead verwendet, der beide Kreisläufe kühlt. Bevorzugt gibt es jedoch des weiteren nur einen Kühlmittelkreislauf in der gesamten Anordnung, wobei jedoch die Kühlung des Kühlmittels außerhalb des Probenkopfes mit mehreren Wärmetauschern bzw. Kühlstufen (Cooler) an verschiedenen Stellen des Kühlkreislaufs erfolgt, so dass in einzelnen Abschnitten des Kühlkreislaufs unterschiedliche absolute Temperaturen einstellbar sind. Die einzelnen Kühlschlaufen des Probenkopfes sind dann jeweils in einzelne solche Abschnitte des Kühlkreislaufs integriert.

Bei einer alternativen, ebenfalls bevorzugten Ausführungsform ist vorgesehen, dass der oder die Wärmetauscher des mindestens einen Detektionskanals und der oder die Wärmetauscher des mindestens einen Sende- oder Entkopplungskanals mit einer gemeinsamen Kühlschlaufe des Fluidums kühlbar sind. Dies vereinfacht den Aufbau eines Kühlsystems. Bevorzugt durchläuft das Fluidum dann zunächst den oder die Wärmetauscher des mindestens einen Detektionskanals, um dort eine leistungsstarke und schwankungsfreie (da direkt vom Cooler kommende) Kühlleistung zu gewährleisten; anschließend werden der oder die weiteren Wärmetauscher des bzw. der Sende/Entkopplungskanäle vom Fluidum durchströmt.

Eine für alle Betriebsarten optimale und einfache Ausführungsform des erfindungsgemäßen Kryokopfes erhält man, wenn die Sende- oder Entkopplungsspulen oder -resonatoren für alle Kanäle auf genau einem Wärmetauscher, nämlich dem weiteren Wärmetauscher sitzen, und die Detektionsspulen oder -resonatoren für alle Kanäle ebenfalls auf genau einem Wärmetauscher, nämlich dem ersten Wärmetauscher sitzen.

Der mindestens eine Sende- oder Entkopplungskanal kann erfindungsgemäß für den gleichen oder auch für einen anderen Kern eingerichtet sein wie der mindestens eine gekühlte Detektionskanal. Beispielsweise kann der Sende/Entkopplungskanal für 13C eingerichtet sein, und der Detektionskanal für 1 H. In einem anderen Beispiel für ein erfindungsgemäßes System sind für Senden und Empfangen von Signalen bezüglich eines Kerns separate Spulen/Resonatoren vorgesehen. Letztere Systeme sind insbesondere in der Medizin vorteilhaft.

Ein Resonator kann erfindungsgemäß für das Senden oder Empfangen von Signalen in Quadratur geeignet sein, insbesondere als Quadratur-Birdcage Resonator. Die beiden HF-Signale werden dann über separate HF-Kabel geführt.

Andere bevorzugte Ausführungsformen können weiterhin den Unteransprüchen entnommen werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1    Erfindungsgemäße Anordnung, zweite Variante, mit Serienschaltung der Wärmetauscher sowie mit Temperaturmessung und Heizungselement zwecks Temperaturregelung des ersten Wärmetauschers;

Fig. 2    Kryokopf mit Kühlsystem nach dem Stand der Technik (Übersicht) mit einem gemeinsamen Wärmetauscher für beide HF Spulen;

Fig. 3    Leistungs-Zeit-Diagramm für pulsweise Entkopplung nach dem Stand der Technik;

Fig. 4    System nach Stand der Technik, mit geregeltem Wärmetauscher für beide HF-Spulen;

Fig. 5    Leistungs-Zeit Diagramm und Temperaturdifferenz-Zeit-Diagramm für pulsweise Entkopplung beim System von Fig. 4 nach dem Stand der Technik - die gemeinsame Temperatur der HF-Spulen zeitaufgelöst, qualitative Darstellung;

Fig. 6    Erfindungsgemäße Anordnung, erste Variante, mit Kühlung der Entkopplungsspule über einen separaten Wärmetauscher;

Fig. 7    Erfindungsgemäße Anordnung, erste Variante, mit Temperaturmessung und Heizungselementen zwecks Temperaturregelung;

Fig. 8    Erfindungsgemäße Anordnung, zweite Variante, mit Serienschaltung der Wärmetauscher sowie Temperaturmessung und Heizungselementen zwecks Temperaturregelung aller Wärmetauscher;

Fig. 9    Leistungs-Zeit-Diagramm und Temperaturdifferenz-Zeit-Diagramm für pulsweise Entkopplung. Die Temperaturen der Detektions- und Entkopplungsspule sind separat aufgeführt. Qualitative Darstellung für das aufgeführte konkrete Beispiel mit einem Wärmetauscher nach dem Stand der Technik

Fig. 10    Thermisches Ersatzschaltbild einer Anordnung gemäß dem Stand der Technik;

Fig. 11    Prinzipielle Analyse des Ersatzschaltbildes und Effizienz eines einzelnen Wärmetauschers;

Fig. 12    Thermisches Ersatzschaltbild der zweiten erfindungsgemäßen Anordnung;

Fig. 13    Leistungs-Zeit-Diagramm und Temperaturdifferenz-Zeit-Diagramme für pulsweise Entkopplung. Die Temperaturen der Detektions- und Entkopplungsspule sind separat aufgeführt. Quantitative Darstellung für das aufgeführte konkrete Beispiel mit zwei Wärmetauschern einer erfindungsgemäßen Anordnung;

Fig. 14    Erfindungsgemäße Anordnung, dritte Variante, mit Parallelschaltung der Wärmetauscher. Temperaturmessung und Heizungselemente zwecks Temperaturregelung aller Wärmetauscher;

Fig. 15    Detail der Wärmetauscheranordnung für die vierte Ausführungsvariante, serielle Schaltung der Wärmetauscher;

Fig. 16    Detail der Wärmetauscheranordnung für die vierte Ausführungsvariante, parallele Schaltung der Wärmetauscher.

## Detaillierte Beschreibung der Erfindung

Im folgenden werden mehrere, bevorzugte Ausführungsformen der Erfindung detailliert erläutert.

Es sei angemerkt, dass im Rahmen der Erfindung Ausführungen über eine HF-Spule in gleicher Weise für einen Resonator gelten und umgekehrt. Auch gelten die Ausführungen für Entkopplungsspulen oder -resonatoren in gleicher Weise für Sendespulen oder -resonatoren und umgekehrt.

## 1. Ausführungsvariante: Vollständige Entkopplung

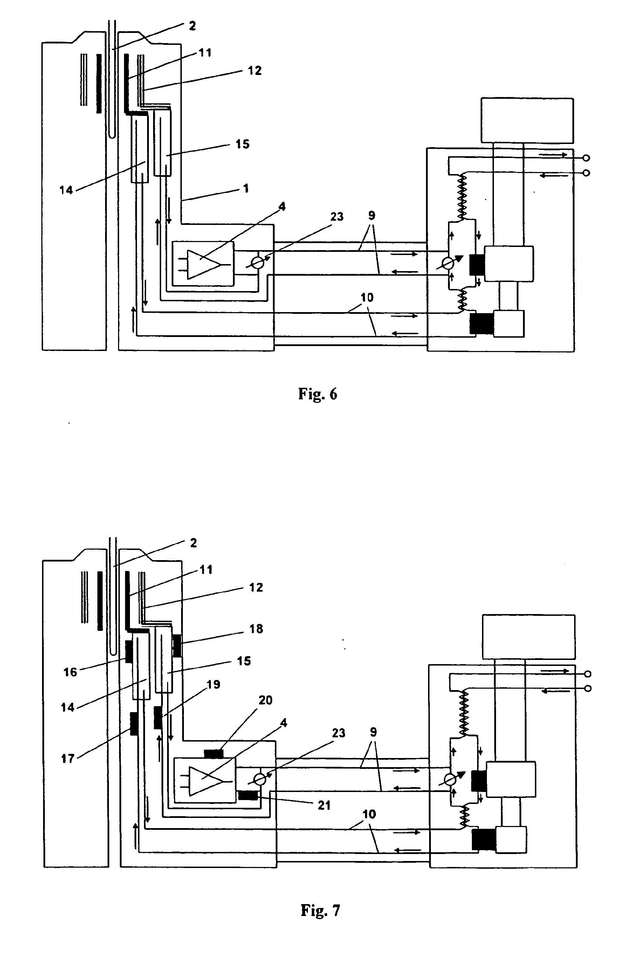

Eine solche Anordnung ist in **Fig. 6** dargestellt. Dabei wird in dieser Ausführungsvariante der Einfachheit halber ein Coldhead für die Kühlung beider Kreisläufe verwendet. Die Entkopplungs-Spule 12 wird durch den "warmen" Kreislauf 9 gekühlt, währenddem die Detektionsspule 11 durch den "kalten" Kreislauf 10 gekühlt wird. In einem solchen Fall würde die Detektionsspule 11 eine Temperatur von <25K aufweisen, und die Entkopplungsspule eine solche von ca. 40-77K, je nach den konkreten Gegebenheiten des verwendeten Coldheads, sowie der konstruktiven Ausführung der Hardware. Die Aufteilung der Kühlleistung zwischen dem Wärmetaucher 15 und der Vorverstärker-Elektronik kann bei Bedarf mit einem Bypass-Drosselventil 23 eingestellt werden.

Währenddem in **Fig. 6** keinerlei Temperaturmessung und -regelung dargestellt ist (ist hier auch nicht zwingend nötig), ist in **Fig. 7** ein Maximalausbau mit bis zu 3 geregelten Temperaturen dargestellt. (Detektionsspule 11: Temperatursensor 16, Heizer 17; Entkopplungsspule 12: Temperatursensor 18, Heizer 19; Vorverstärker-Elektronik: Temperatursensor 20, Heizer 21.) Neben der Regelung der Vorverstärker-Elektronik mittels 20 und 21, auf die wir hier nicht näher eingehen wollen, kann mittels des Temperatursensors 18 und des Heizers 19 auch die Entkopplungsspule auf eine genaue mittlere Temperatur geregelt werden. Die kann zugunsten der Langzeitstabilität des Systems von Vorteil sein.

Eine Anordnung gemäß **Fig. 6** oder **Fig. 7** hat den großen Vorteil, dass die thermische Last der Entkopplungsspule 12 sich nur noch sehr indirekt, auf in der Praxis verschwindende Weise, auf den kalten Kreislauf 10 und somit die Detektionsspule 11 auswirkt. Dies wird dadurch begünstigt, dass die beiden Kennlinien (Temperatur vs. Wärmelast) der beiden Cryocoolerstufen 7 und 8 typischerweise weitgehend entkoppelt sind. Insbesondere ist oft die Kühlleistung der zweiten Stufe praktisch unabhängig von der Last auf der ersten Stufe, wie den Kennlinien des Coldheads entnommen werden kann. Zusätzlich fällt hier auch ins Gewicht, dass die erste Stufe des Coldheads eine im Vergleich zur zweiten Stufe immense Kühlleistung hat (typischerweise über. 20W der ersten Stufe 7 im Vergleich zu 1-5W der zweiten Stufe 8). Somit werden Entkopplungsleistungen vertragen, die im Vergleich zum Stand der Technik extrem hoch liegen.

Der zweite Vorteil ist, dass die Detektionsspule und ihr Kühlsystem ohne jegliche unnötige Wärmelast betrieben werden können. Somit sind die tiefstmöglichen Temperaturen der Detektionsspule erreichbar.

Der dritte Vorteil ist, dass die Temperatur der Detektionsspule zeitlich sehr konstant ist, denn die gepulsten Leistungsspitzen werden durch die separate Kühlschlaufe 9 und die große Masse und damit hohe spezifische Wärme des Coldheads 6 mit seinen Stufen 7 und 8 sowie seiner Wärmetauscher 38, 32, 8, 33 praktisch vollständig ausgefiltert.

Insgesamt ergeben sich mit einer solchen Anordnung ideale Verhältnisse für die Detektionsspule 11: Tiefstmögliche Temperatur, völlige Temperaturstabilität. Die Entkopplungs-Spule 12 hat gleichzeitig eine sehr hohe Kühlleistung zur Verfügung.

Diese Anordnung hat immense Vorteile, aber insbesondere bei Verwendung desselben Coldheads für beide Kreisläufe auch gewisse Nachteile, die je nach Verwendungsart der Kopfes sich negativ auswirken können:

a) Die Entkopplungs-Spule 12 wird auf einer höheren Temperatur betrieben, verglichen mit dem Stand der Technik. Dies ist insofern ein Nachteil, als dass ihr HF-Widerstand i.A. nicht so tief ist wie bei einer tieferen Temperatur möglich wäre und somit mehr Leistung für den gleichen Spulenstrom (=gleiche HF-Feldstärke) benötigt wird. Andererseits gibt es auch Anwendungen, bei denen auf der Entkopplungs-Spule empfangen wird. Eine solche bei einer hohen Temperatur betriebene Spule hat dann ein nicht optimales S/N. Des weiteren sind HF Verluste bei der Detektionsfrequenz, die sich durch die Präsenz der Entkopplungs-Spule und die unvermeidbaren Hochfrequenzkopplungen der Detektions- mit der Entkopplungsspule ergeben, etwas höher als im Falle, wenn die Entkopplungs-Spule so kalt wie die Detektionsspule wäre (erhöhter HF-Widerstand und somit höhere Verluste, zudem ergibt sich wegen der höheren physikalische Temperatur eine erhöhte Rauschleistung für einen gegebenen Güteverlust der Detektionsspule).

## 2. Ausführungsvariante: Serielle Kühlung

In Fällen, wo die Nachteile der 1.Ausführungsvariante für die Anwendung als zu schwerwiegend beurteilt werden oder bei Systemen, bei denen gar kein zweiter Kühlkreislauf zur Verfügung steht, kann eine vereinfachte Ausführung verwendet werden, die auf den ersten Blick als nicht besonders sinnvoll oder innovativ erscheint, aber bei genauer Analyse sehr große Vorteile bringt:

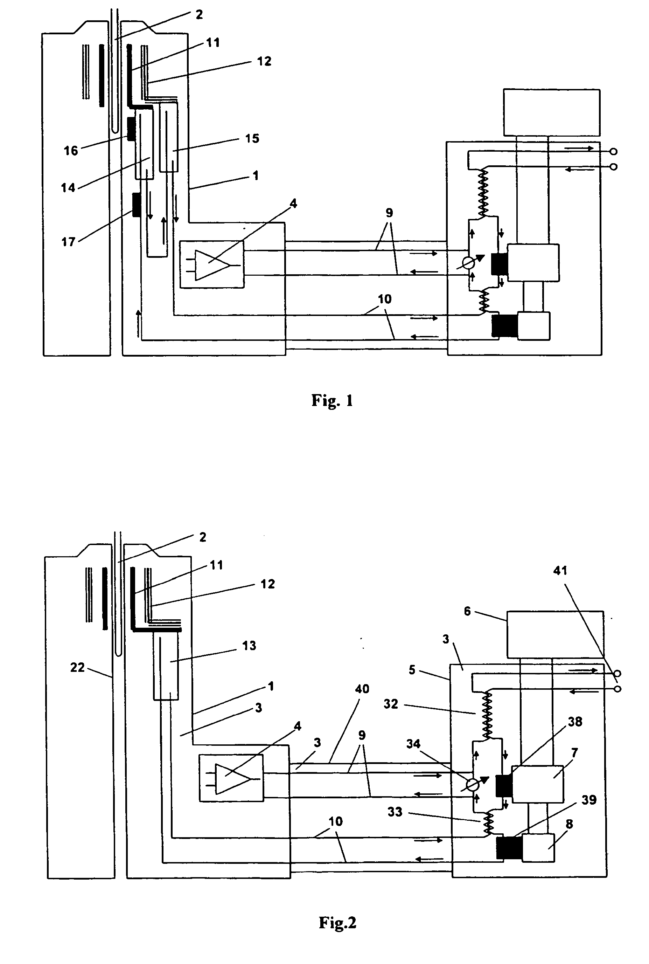

Eine solche Anordnung ist in Fig. 1 dargestellt. Der Wärmetauscher 15 der Entkopplungsspule 12 wird nicht wie im 1.Ausführungsbeispiel vom "warmen" Kreislauf 9 gekühlt, sondern direkt ebenfalls vom "kalten" Kreislauf 10, so wie der Wärmetauscher 14 der Detektions-Spule 11 auch. Es ist jedoch ganz wesentlich, dass die beiden Wärmetauscher nicht direkt thermisch miteinander gekoppelt sind, sondern in Serie hintereinander verschlauft sind, wobei vorteilhafterweise der Detektions-Wärmetauscher 14 zuerst mit dem kalten He gespeist wird.

Die Funktionsweise einer solchen Anordnung kann wie folgt beschrieben werden:

a) Das kalte He von der Cooler-Stufe 2 (8) geht direkt in den Wärmetauscher 14 im Kryokopf. Der Wärmetauscher wird optional auf einer konstanten Temperatur mittels eines Heizers 17 und Temperatursensors 16 geregelt. Der Heizer 17 kann im Kreislauf irgendwo vor dem Wärmetauscher 14 oder auch an diesem selbst angeordnet sein.

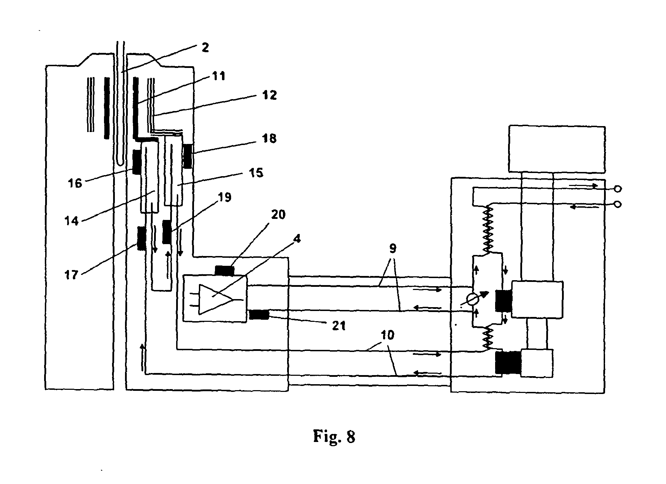

b) Erst nachdem das He-Kühlmedium den ersten Wärmetauscher 14 durchströmt hat, tritt es in den zweiten Wärmetauscher 15 ein und kühlt diesen. Dieser kann nun in der Temperatur freilaufend (ungeregelt) sein (wie in **Fig. 1** dargestellt), oder aber wie in **Fig. 8** dargestellt, mittels eines zweiten Heizers 19 und Temperatursensors 18 ebenfalls auf einer konstanten mittleren Temperatur geregelt sein. Diese Regel-Soll-Temperatur für T2 des Entkopplungswärmetauschers 15 würde dann auf jeden Fall etwas höher als die Temperatur T1 des Detektionswärmetauschers 14 gesetzt sein. Neben der Regelung der Vorverstärker-Elektronik mittels 20 und 21, auf die wir hier nicht näher eingehen wollen, kann somit mittels des Temperatursensors 18 und des Heizers 19 auch die Entkopplungsspule auf eine genaue mittlere Temperatur geregelt werden. Die kann zugunsten der Langzeitstabilität des Systems von Vorteil sein.

### Analyse:

Im Folgenden soll das thermische Verhalten der erfindungsgemäßen Anordnung gemäß **Fig. 1** mit dem thermischen Verhalten eines Systems gemäß dem Stand der Technik (**Fig. 4**) verglichen werden

Der Einfachheit halber wird hier das System gemäß **Fig. 1** analysiert und diskutiert. (Die geregelte Version auch auf dem Wärmetauscher 15 gemäß **Fig. 7** wird hier nicht explizit diskutiert, hat aber nur den einzigen Unterschied, dass die Temperatur der Entkopplungsspule 12 im Mittel ebenfalls konstant bleibt. Die minimal erreichbaren Temperaturen während der Entkopplung sowie die dynamischen Temperaturschwankungen bleiben aber praktisch identisch.)

Wir beginnen die Analyse zuerst mit einer Analyse des Systems gemäß dem Stand der Technik, und analysieren dann die erfindungsgemäße Anordnung.

### 1. Analyse der Anordnung nach dem Stand der Technik

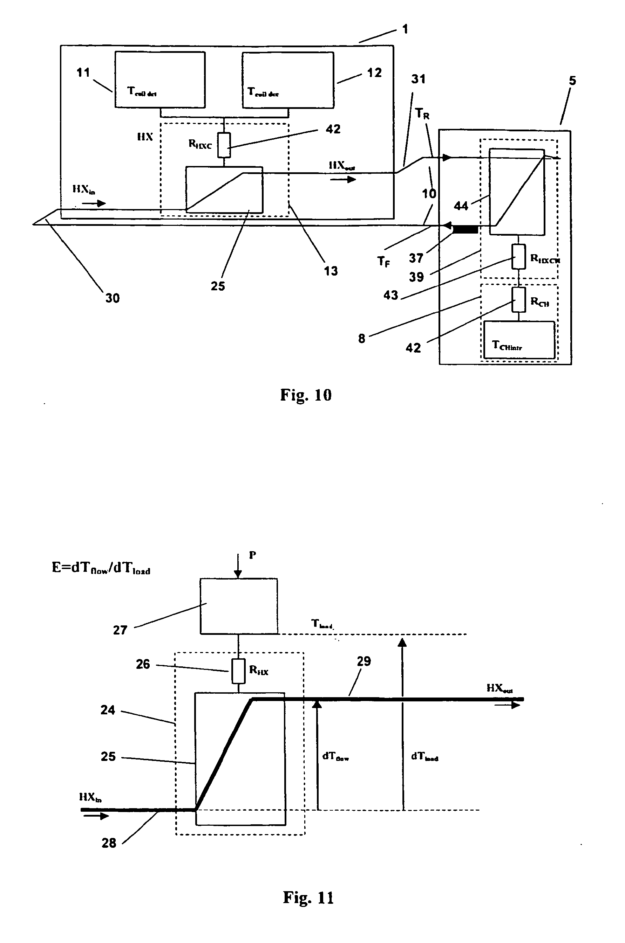

Für das Verständnis ist ein Ersatzschaltbild nötig. In **Fig. 10** ist das Ersatzschaltbild einer Anordnung nach dem Stand der Technik dargestellt, gemäß **Fig. 2.**

Es wird hier nur der Kreislauf 10 dargestellt, der die HF-Spulen kühlt. Dieser wird im Kühlsystem abgekühlt, und gibt seine Kälte in der Cryoprobe ab. Dabei kühlt er die HF-Spulen. Vom Kühlsystem ist hier nur der Wärmetauscher 39 der zweiten Stufe 8 des Coldheads 6 dargestellt. Es wird hier der Einfachheit halber angenommen, dass das He-Gas im Kreis herumströmt. (In Wirklichkeit wird es über Gegenstrom-Wärmetauscher 33 zum bei Raumtemperatur befindlichen Zirkulationskompressor und zurück geleitet. Dies ist jedoch für die hier durchgeführten Betrachtungen ohne Belang und wir können annehmen, dass das He beim Wiedereintritt ins Kühlsystem 5 anstatt zum Gegenstrom-Wärmetauscher 33 zu gehen, direkt wieder in den Stufen-Wärmetauscher 39 eintritt. Dies ist darum zulässig, da die Gegenstrom-Wärmetauscher nur zu einer thermischen Isolation des Kompressors von den kalten Stufen führen, und das aus dem Gegenstrom-Wärmetauscher 33 austretende Helium praktisch die gleiche Temperatur aufweist wie das in diesen eintretende.)

Um die Darstellung verständlicher zu machen, sind in Fig. 10 diejenigen Teile, die eine höhere Temperatur haben, weiter oben gezeichnet. Dies gilt sowohl für die Einzelteile, wie auch für der Gasfluss selbst:

Das He wird mit dem Wärmetauscher 39 abgekühlt. Die Ausgangstemperatur $T_F$ des aus dem Kühlsystem 5 austretenden Gasstromes ist nun abhängig von der total dissipierten Leistung im Kühlkreislauf. Der Coldhead hat eine gewisse Kennlinie, die beschreibt, wie seine Temperatur mit zunehmender thermischer Belastung ansteigt. Um diese Kennlinie für die nachfolgenden Betrachtungen möglichst einfach darzustellen, wird angenommen, der Coldhead selbst befinde sich bei einer gegeben (intrinsischen) Temperatur $T_{CHintr}$. Dies ist die Temperatur, die die zweite Stufe 8 des Coldheads hätte, wenn keine HF Leistungen im Kopf dissipiert würden.

$$T_F = T_{CHintr} + \{P\}^* (R_{CH} + R_{HXCH}) \qquad \text{Eq. 1a}$$

Dabei ist {P} die mittlere gesamte vom Kryokopf kommende, (über Zeiträume größer oder gleich der Periode 52 des Experiments) zeitlich gemittelte Wärmelast.

$R_{CH}$ ist der äquivalente thermische Widerstand des Coldheads (hier seiner zweiten Stufe 8), der eine Zunahme der Temperatur als Funktion der dissipierten Leistung angibt, und somit seine Kennlinie beschreibt. Der Wärmewiderstand $R_{HXCH}$ ist der innere Wärmewiderstand des Wärmetauschers und beschreibt seine Ineffizienz. Für die nachfolgenden Betrachtungen können wir $R_{HXCH}$, da im Cooler genügend Platz für einen großen, praktisch 100% effizienten Wärmetauscher ist, vernachlässigen (oder es kann auch rechnerisch $R_{HXCH}$ zu $R_{CH}$ geschlagen werden). Somit ergibt sich für unsere Analyse

$$T_F = T_{CHintr} + \{P\}^* R_{CH} \qquad \text{Eq. 1b}$$

Diese Linearisierung der Coldheadkennlinie ist für unsere Betrachtungen vollkommen genügend.

Das He geht nun durch die Zuleitung 10 zum Kryokopf. Auf diesem Weg erleidet es eine kleine Erwärmung in der Transferleitung, (durch 30 dargestellt), die wir jedoch hier ebenfalls vernachlässigen wollen, da sie klein und konstant ist.

Nun tritt das He Gas in den Kopf ein, und kommt dort in den Wärmetauscher HX (13). Durch diesen kühlt es beide HF Spulen, d.h. die Detektionsspule 11 und die Entkopplungsspule 12 auf die Arbeitstemperatur ab.

Auf dem Rückweg in den Cooler erleidet das Gas eine weitere kleine Erwärmung 31, die wir hier ebenfalls vernachlässigen wollen.

Nun schließt sich der Zyklus. Das He, das sich auf dem Weg, ausgehend von der Temperatur $T_F$ durch die Aufnahme der Wärme aus dem Kryokopf aufgewärmt hat, besitzt nun die Temperatur $T_R$ und kommt wieder in den Wärmetauscher 39 des Coldheads, wo es wieder abgekühlt wird und der Kreislauf von vorne beginnt.

Für die weitere Analyse ist das Verhalten des He-Gases in den Wärmetauschern von Belang. Dies soll hier kurz erläutert werden.

In **Fig. 11** ist ein einzelner Wärmetauscher schematisch dargestellt.

Der ganze Wärmetauscher 24 ist gestrichelt dargestellt. Dieser ist im Inneren aufgeteilt in einen gedanklichen, 100% effizienten Wärmetauscher 25, in Serie mit einem Wärmewiderstand 26 $R_{HX}$, der die Ineffizienz des Wärmetauschers beschreibt (siehe Eq. 4 sowie Eq. 10 weiter unten). Links strömt Gas hinein (28) mit der Temperatur $HX_{in}$. Der Wärmetauscher 24 ist an das zu kühlende Objekt 27 thermisch angeschlossen. Dieses gibt die Wärmelast P ab. Das zu kühlende Objekt 27 wird auf die Temperatur $T_{load}$ abgekühlt.

Die thermische Leistung P führt andererseits zu einer Erwärmung des Gasstromes. Dieser verlässt den Wärmetauscher mit der Temperatur $HX_{out}$. Dabei gilt

$$HX_{out} = HX_{in} + dT_{flow} \qquad \text{Eq. 2}$$

Gemäß dieser Schreibweise hat sich der Gasstrom also um die Temperatur $dT_{flow}$ erwärmt.

Wir definieren

$$dT_{load} = T_{load} - HX_{in} \qquad \text{Eq. 3}$$

als die Temperaturdifferenz zwischen der Temperatur $T_{load}$ der Last und der Temperatur $HX_{in}$ des eintretenden Gasstromes.

Durch einen Wärmetauscher mit 100% -iger Effizienz würde das Objekt bis auf die Austrittstemperatur $HX_{out}$ abgekühlt. In diesem Fall wäre $dT_{load} = dT_{flow}$. Bei einer unter 100% liegenden Effizienz. wird $dT_{load} > dT_{flow}$.

Die Effizienz E des Wärmetauscher definieren wir allgemein als

$$E = dT_{flow}/dT_{load} \qquad \text{Eq. 4}$$

Nun ist es zunächst wichtig zu wissen, wie viel bei einer gegebenen Belastung $dT_{flow}$ beträgt.

Dies kann ausgedrückt werden als die fortlaufende Erwärmung der Gaspakete, die durch den Wärmetauscher strömen. Es ergibt sich die Beziehung zur Leistung P wie folgt:

$$P = (dm/dt) * Cp * dT_{flow} \qquad \text{Eq. 5}$$

dabei ist dm/dt der Massenfluss des Gases pro Zeiteinheit, und Cp die spezifische Wärme.

Diese Enthalpiebilanz ist die Grundlage für die Kühlleistung im Wärmetauscher.

Die Beziehung Eq. 5 kann mit der Einführung einer neuen Variablen $R_{He}$ wie folgt ausgedrückt werden:

$$dT_{flow} = R_{He} * P \qquad \text{Eq. 6}$$

$R_{He}$ ist dabei wie folgt definiert:

$$R_{He} = 1/(Cp * dm/dt) \qquad \text{Eq. 7}$$

Andererseits ist aber der Temperaturabfall über $R_{HX}$ gegeben durch

$$(dT_{load} - dT_{flow}) = R_{HX} * P \qquad \text{Eq. 8}$$

Somit erhält man durch Einsetzten von Eq. 6 in Eq. 8 den folgenden Ausdruck, der für die nun folgende quantitative Analyse sehr praktisch ist:

$$dT_{load} = P * (R_{He} + R_{HX}) \qquad \text{Eq. 9}$$

Dabei ist $R_{He}$ durch den Massenfluss gemäß Eq. 7 gegeben. $R_{HX}$ kann mit der Effizienz E des Wärmetauschers unter Verwendung der Eqs. 4,6, und 8 wie folgt ausgedrückt werden:

$$R_{HX} = R_{He} (1/E - 1) \qquad \text{Eq. 10}$$

Die Eq. 8 erlaubt es, die relevanten Temperaturunterschiede in praktischen und gut bestimmbaren Größen auszudrücken.

Für die quantitative Analyse verwenden wir typische Werte für die vorkommenden Variablen:

Für die Cooler-Kennlinie wollen wir bei der Arbeitstemperatur der zweiten Stufe einen typischen Wert annehmen von

$$R_{CH} = 0.6 \text{ K/W} \qquad \text{Eq. 11}$$

Bei einem Massenfluss in der Schlaufe 10 von ca. 100 Norm-Litern He (100nl) pro Minute und der bekannten spezifischen Wärme Cp von

$$Cp_{He} = 5200\ J/(K^*kg) \qquad Eq.\ 12$$

von gasförmigem Helium ergibt sich aus Eq. 7 ein äquivalenter Wärmewiderstand des Heliums $R_{He}$ von ungefähr

$$R_{He} = 0.6\ K/W \qquad Eq.\ 13$$

(Die genaue Gleichheit der Werte mit Eq. 11 ist zufällig, vereinfacht aber die nachfolgenden Berechnungen. Es ist auch sinnvoll, dass $R_{He}$ möglichst nicht größer als $R_{CH}$ ist, um die an sich unnötigen Wärmeübertragungsverluste niedrig zu halten.) Dieser äquivalente Widerstand $R_{He}$ drückt einfach aus, um wie viel das gasförmige He in einem Wärmetauscher erwärmt werden muss, um eine gewisse Leistung abzuführen (Eq. 6). Es ist wünschenswert, $R_{He}$ möglichst niedrig zu halten. Der Wert von $R_{He}$ kann aber durch nichts außer Erhöhung des Massenflusses verringert werden. Die Erhöhung des Massenflusses ist technisch schwierig und stößt bald auf praktische Grenzen, da durch die zunehmenden Reibungs- und Druckverluste die Effizienz der Kühlschlaufe 10 bei zu hohen Massenflüssen rapide absinkt. Somit sind dem $R_{He}$ leider Grenzen nach unten gesetzt, sodass die Übertragungsverluste in der Praxis nicht unter ein gewisses Maß verringert werden können.

Für die nun folgende Analyse ist es ganz wichtig zu realisieren, dass wir es mit im Wesentlichen zwei Leistungsbereichen zu tun haben:

1. Wir haben eine mittlere Leistung, die wir mit {P} bezeichnen, und die im wesentlichen von der Entkopplungsspule 12 generiert wird und abgeführt werden muss, und in der Folge über den Wärmetauscher 13 und das Helium im Coldhead endet und von diesem abgeführt werden muss. Die Herausforderung hier ist vor allem, dass diese mittlere Leistung eine möglichst geringe Erwärmung der Detektionsspule zur Folge hat.

2. Das zweite Problem kommt jedoch zusätzlich davon, dass die Leistung nicht stetig, sondern pulsweise auftritt, mit einer während der Pulse sehr hohen Leistung (bei Entkopplungspulsen typischerweise 5 x mehr als die mittlere Leistung). Die schwierige Sachlage besteht nun darin, dass gerade während der Entkopplung empfangen wird. Es ist also entscheidend, was genau während der Entkopplungszeitabschnitte passiert. Das System muss auf diese hohe Leistung ausgelegt werden.

Für die Leistungen wollen wir als Beispiel die konkreten Werte angeben:

$$P_{peak} = 10\ W \qquad Eq.\ 14$$

Wegen Duty-Cycle D von

$$D = 0.2 \qquad Eq.\ 15$$

ergibt sich eine mittlere Leistung {P} von

$$\{P\} = D^* P_{peak} = 2W \qquad Eq.\ 16$$

Eine Tatsache erleichtert allerdings glücklicherweise die Verhältnisse etwas: Der Coldhead besitzt eine hohe thermische Kapazität, und somit wird dieser (d.h. seine Kennlinie) nur mit der mittleren Leistung belastet, und es kann in der ersten Approximation auch davon ausgegangen werden, dass die Temperatur $T_F$ des aus dem Kühlsystem austretenden Heliums während und zwischen den einzelnen Pulsen nicht stark schwankt. Somit kann das $T_F$ als durch die mittlere Leistung {P} gegeben, dann aber als kurzzeitig recht konstant betrachtet werden. Davon ausgehend können dann die weiteren Auswirkungen der Pulsleistung untersucht werden.

Wir bezeichnen die Temperatur der HF-Spulen mit $T_c$. Es gilt dann mit Ausnutzung von Eq. 9 die Beziehung:

$$T_c = T_F + P^* (R_{He} + R_{HX}) \qquad \text{Eq. 17}$$

Wird für $T_F$ der Ausdruck aus Eq. 1 b eingesetzt, ergibt sich

$$T_c = T_{CHintr} + \{P\}^* R_{CH} + P^* (R_{He} + R_{HX}) \qquad \text{Eq. 18}$$

Wenn wir als $\Delta T_c$ die Änderung der Temperatur der HF Spulen 11 und 12 bei der Entkopplung gegenüber der Temperatur ohne Entkopplung bezeichnen gemäß

$$\Delta T_c = T_c - T_{CHintr}, \qquad \text{Eq. 19}$$

so erhalten wir für $\Delta T_c$ den Ausdruck

$$\Delta T_c = \{P\}^* R_{CH} + P^* (R_{He} + R_{HX}) \qquad \text{Eq. 20}$$

Diesen wollen wir nun nachfolgend evaluieren. Dabei bedeutet P die instantane Leistung, und {P} die mittlere Leistung (über die Periode 52 des Experiments oder länger gemittelt)

**A. Mittlere Erwärmung der Entkopplungsspule**

Für die mittlere Erwärmung $\{\Delta T_c\}$ müssen wir in Eq. 20 auch bei P das gemittelte {P} einsetzen.
Dies ergibt gemäß den Vorgaben bei einem 100% wirksamen Wärmetauscher 13 gemäß Eq. 10 und 13

$$R_{HX} = R_{He} (1/E - 1) = 0 \qquad \text{Eq. 21}$$

Somit ergibt sich gemäß Eqs. 11, 13, 16, sowie aus Eq. 20

$$\{\Delta T_c\} = 2W^*0.6K/W + 2W^* 0.6K/W = 2.4 \text{ K} \qquad \text{Eq. 22}$$

Bei einer Effizienz des Wärmetauschers 13 unter 100%, ergibt sich ein höherer Wert. Für E = 50% ergibt sich, da nun der Term $R_{HX}$ nicht mehr Null ist, sondern durch Eq. 10 gegeben wird, ein zusätzlicher Beitrag von $R_{HX}$ in Eq. 20, und somit

$$\{\Delta T_c\} = 2W^*0.6K/W + 2W^* (0.6K/W + 0.6K/W) = 3.6 \text{ K} \qquad \text{Eq. 23}$$

Wir sehen also, dass in diesem Beispiel bei einer Anordnung gemäß dem Stand der Technik eine mittlere Erwärmung der Entkopplungs- und somit auch der Detektionsspule bei perfekten Wärmetauschern von 2.4 K, bei einem 50% effizienten Wärmetauscher im Kryokopf eine solche von 3.6K ergibt.

**B. Erwärmung der Entkopplungsspule während des Pulses:**

Wir wollen nun die Peak-Temperatur $T_{cpeak}$ bestimmen, die während des Entkopplungspulses auftreten kann. Dies ergibt gemäß Eq. 20 für die Änderung $\Delta T_{cpeak}$ die Änderung der Temperatur bei Entkopplung gegenüber der Temperatur ohne Entkopplung:

$$\Delta T_{cpeak} = \{P\}^* R_{CH} + P_{peak}^* (R_{He} + R_{HX}) \qquad Eq. 24$$

Dabei setzen wir für {P} den Wert gemäß Eq. 16 und für die Leistung P die Peakleistung $P_{peak}$ gemäß Eq. 14. Dies ergibt für einen Wärmetauscher 13 mit einer Effizienz von 100% (Analog zu Eq. 22)

$$\Delta T_{cpeak} = 2W^*0.6K/W + 10W^* 0.6K/W = 7.2 K \qquad Eq. 25$$

und für einen Wärmetauscher 13 mit einer Effizienz 50% (analog zu Eq. 23)

$$\Delta T_c = 2W^*0.6K/W + 10W^* (0.6K/W + 0.6K/W) = 13.2 K \qquad Eq. 26$$

Die obigen Resultate sind in der **Tabelle 1 (A)** zusammengefasst.

Tabelle 1: Temperaturzunahme während Pulsen bei verschieden effizientem Wärmetauscher HX (bei den im Text angegebenen Bedingungen).

| Effizienz des Wärmetauschers HX | Coolererwärmung | Temperaturzunahme (zusätzlich zur Coolererwärmung) während Puls am HX | Mittlere Temperaturzunahme am HX (total), entspricht der mittleren Temperaturzunahme der Detektionsspule | Min. Temperaturzunahme am HX | Temperaturexkursion (Tmax-Tmin) der Entkopplungsspule | Max. Temperaturzunahme Entkopplungsspule (total) | Max. T-Exkursion der Detektionsspule | Max. T-Zuname der Detektionsspule |
|---|---|---|---|---|---|---|---|---|
| 100% | **1.2K** | 6 K | **2.4 K** | 1.2K | 6 K | 7.2 K | **6 K** | **7.2 K** |
| 50% | **1.2K** | 12 K | **3.6 K** | 1.2K | 12 K | 13.2K | **12 K** | **13.2 K** |
| 20% | **1.2K** | 30 K | **7.2 K** | 1.2K | 30 K | 31.2K | **30 K** | **31.2K** |

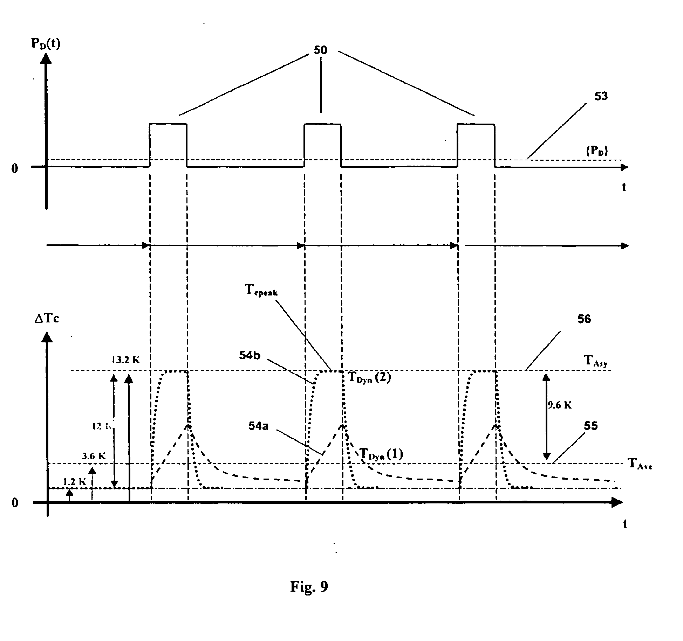

Die zeitabhängigen Verhältnisse dazu sind in **Fig. 9** quantitativ dargestellt (nur für den Fall eines 50%-ig effizienten Wärmetauschers. Bei anderen Effizienzen sind die entsprechenden Zahlen aus Tabelle 1 zu entnehmen oder anhand der angegebnen Formeln zu berechnen)).

**Erwärmung der Detektionsspule**

Werden die 1 H und X Spule mit dem gleichen Wärmetauscher betrieben, so erleidet auch die Detektionsspule eine einerseits mittlere Temperaturzunahme um (bei einem 50%-igem Wärmetauscher) 3.6 K, und dazu noch eine (leider genau während der Akquisition vorkommende, graduelle oder sprunghafte) Erwärmung um weitere 9.6 K. Dies hat die im Abschnitt 2.4 aufgeführten Nachteile zur Folge:

a) **Das S/N wird verschlechtert** (Rauschtemperatur steigt um bis zu 13.2K gegenüber dem nicht entkoppelten Fall). Dies führt zu einer wesentlichen S/N Verschlechterung, da die Rauschleistung der HF Spule proportional zu deren physikalischer Temperatur ist.

b) **Die Spule kann sich verstimmen**, und es können sich Spektren mit einem Phasenfehler ergeben.

Man sieht in der **Tabelle 1** übrigens, dass auch bei einer Effizienz von 100% sowohl die Temperaturexkursion wie die max. Temperatur der Detektionsspule bereits sehr hoch sind. Sinkt die Effizienz jedoch auf oder unter 50%, werden diese Werte prohibitiv groß.

**2. Analyse der erfindungsgemäßen Anordnung (gemäß 2. Ausführungsvariante)**

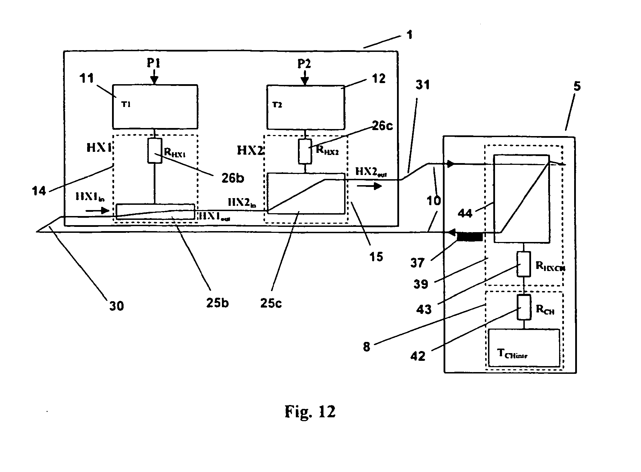

In **Fig. 12** ist hingegen das Ersatzschaltbild einer erfindungsgemäßen Anordnung gemäß **Fig. 1** dargestellt.

Es sind dabei 2 Wärmetauscher zu betrachten HX1 (14) für die Detektionsspule, und HX2 (15) für die Entkopplungsspule. Es ist für die untenstehenden Betrachtungen und für die optimale Funktion wichtig, dass sie in der angegebenen Reihenfolge durchflossen werden. Die Detektionsspule 11 dissipiere die Leistung P1, die Entkopplungsspule 12 die Leistung P2.

Für die Temperaturen T1 der Detektionsspule und T2 der Entkopplungsspule ergibt sich:

$$T1 = T_F + P1^* (R_{He} + R_{HX1}) \qquad Eq.\ 27$$

$$T2 = T_F + P1^*R_{\cdots} + P2^* (R_{He} + R_{HX2}) \qquad Eq.\ 28$$

wobei $T_F$ durch gemäß Eq. 1b gegeben ist:

$$T_F = T_{CHintr} + \{P\}^* R_{CH} \qquad Eq.\ 1b$$

wobei die mittlere Leistung durch

$$\{P\} = \{P1+P2\} \qquad Eq.\ 29$$

gegeben ist.

Die Auswertung der Temperaturzunahme der Detektionsspule $\Delta T1$ ergibt sich wie oben zu

$$\Delta T1 = P1^* (R_{He} + R_{HX}) + \{P\}^* R_{CH} \qquad Eq.\ 30$$

Da wir nur den Einfluss der Entkopplungsspule betrachten, vernachlässigen wir P1. Somit ist sowohl P1=0 wie auch in Eq. 29 {P}={P1}. Dies ergibt nun aus Eq. 30 die Eq. 31:

$$\Delta T1 = \{P2\}^* R_{CH} \qquad \qquad Eq.\ 31$$

Man sieht dann hier, dass in Eq. 31 lediglich der Mittelwert {P2} der Entkopplungsleistung P2 vorkommt, der momentane Wert (und somit auch jegliche hohe Pulsleistungswerte) nicht mehr vorkommen. Die durch die He-Enthalpie gegebene Temperaturerhöhung kommt nicht mehr vor (das System verhält sich so, wie wenn der He Fluss unendlich groß wäre!) Es kommt auch der Wärmewiderstand $R_{HX2}$ und somit auch die Effizienz des Wärmetauschers (HX2) nicht mehr vor!

Die Erwärmung der Detektionsspule ist also nur noch von der mittleren Leistung {P}={P2} am Cooler und der Kennlinie des Coolers abhängig.

Eine Auswertung der Eq. 31, analog zur **Tabelle 1** ergibt die **Tabelle 2**.

Tabelle 2: Temperaturzunahme während Pulsen bei verschieden effizientem Wärmetauscher HX2 der Entkopplungsspule (bei den im Text angegebenen Bedingungen).

| Effizienz des HX2 | Coolererwärmung | Temperaturzunahme (zusätzl. zur Coolererwärmung) während Puls am HX2 | Mittlere Temperaturzunahme am HX2 (total) | Min. Temperaturzunahme am HX2 | Temperaturexkursion (Tmax-Tmin) der Entkopplungsspule | Max. Temperatuzunahme Entkopplungsspule (total) | Max. T-Exkursion der Detektionsspule | Max. T-Zunahme der Detektionsspule |
|---|---|---|---|---|---|---|---|---|
| 100% | 1.2K | 6 K | 2.4 K | 1.2K | 6 K | 7.2 K | **0 K** | **1.2K** |
| 50% | 1.2K | 12 K | 3.6 K | 1.2K | 12K | 13.2K | **0 K** | **1.2K** |
| 20% | 1.2K | 30 K | 7.2 K | 1.2K | 30 K | 31.2K | **0 K** | **1.2K** |

**Diskussion:**

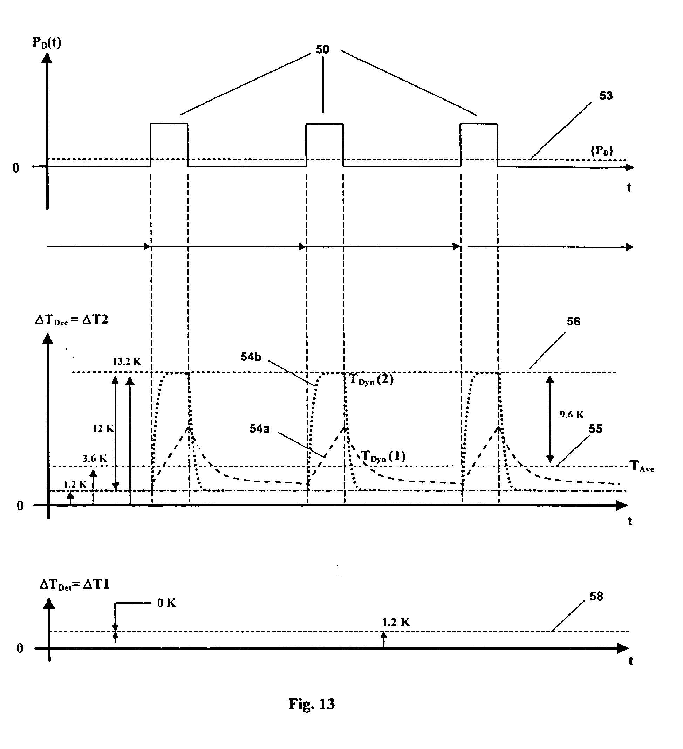

**Fig. 13** zeigt die Temperaturen der Detektions- und Entkopplungsspule zeitaufgelöst. Im Gegensatz zu **Fig. 9,** wo nur eine Temperatur $T_C$, die gemeinsame Temperatur beider Spulen angezeigt wurde, werden in **Fig. 13** die beiden Temperaturen T1 und T2 der Detektions- resp. der Entkopplungsspule separat dargestellt. $\Delta T1$ wird hier auch als $\Delta T_{Det}$ bezeichnet, und $\Delta T2$ auch als $\Delta T_{Dec}$ zur Klarstellung, was die Detektionsspulentemperatur und was die Entkopplungsspulentemperatur darstellt.

Die Schwankungen der Temperatur T1 betragen nun unabhängig von der Effizienz des WT2 nun mit sehr guter Näherung NULL ! (Dies kommt davon, dass durch die erfindungsgemäße Anordnung der Wärmefluss der Entkopplungsspule den WT1 gar nicht erreicht und sozusagen an ihm vorbeigeht. Es soll hier bemerkt werden, dass allfällige Schwankungen von $T_F$ bei dieser Anordnung sehr klein und langsam sind, und i.A. durch die beschriebene optionale Regelung mittels Temperatursensor 16 und Heizer 17 sehr einfach bis auf verschwindend kleine Restschwankungen ausgeregelt werden können.

Die Vorteile dieser Ausführungsvariante gegenüber dem Stand der Technik lassen sich wie folgt zusammenfassen:

  1. Die Effizienz der Wärmetauscher im Kopf spielt keine Rolle mehr.
  2. Die Größe des He-Massenflusses spielt keine Rolle mehr
  3. Die kurzfristigen Temperaturschwankungen der Detektionsspule sind praktisch Null. Dies ist im starken Kontrast gegenüber dem Stand der Technik, wo sehr hohe Schwankungen (von z.B. (12K bei 50% Effizienz) auftreten können.
  4. Die mittlere Erwärmung der Detektionsspule gegenüber dem unbelasteten Fall ist absolut minimal (1.2K gegenüber 3.6K bei 50%-ig effizientem Wärmetauscher). Die mittlere Zunahme (1.2K) lässt sich durch eine Regelung (Flow Heater 37 in Fig. 12 oder Heizer 17 im Probenkopf in Fig. 1, zusammen mit einer Temperaturmessung am Temperatursensor 16) auf Null bringen, wenn von Anfang an der Regelpunkt entsprechend höher gesetzt wird (mindestens 1.2K über dem unbelasteten Fall). Dieser Wert von 1.2K ist absolut minimal, durch den Cooler gegeben und nicht weiter zu unterbieten.

Es muss besonders hervorgehoben werden, dass die erfindungsgemäße Erweiterung auf zwei Wärmetauscher eine eigentlich unerwartete und sehr wesentliche Verbesserung der Performance möglich macht, und einige der Schranken, die durch endliche Effizienz von Wärmetauschern und der Wärmeübertragung durch das gasförmige He gegeben waren, sprengt und mit einer Lösung ersetzt, die praktisch perfekt ist.

### 3. Ausführungsvariante: Parallele Kühlung

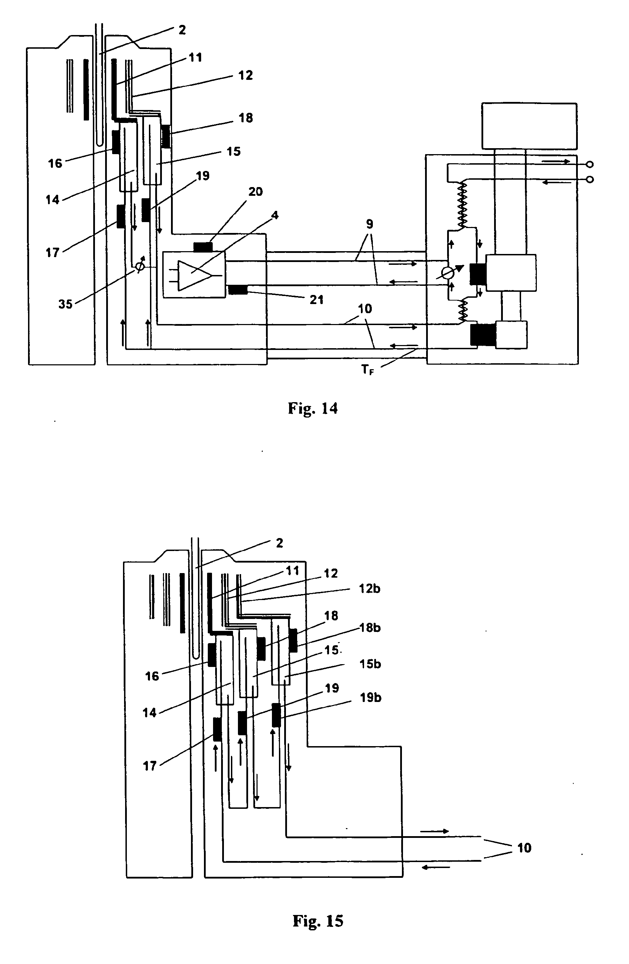

Eine etwas abgeänderte Variante der 2. Ausführungsvariante besteht darin, dass der Wärmetauscher 15 der Entkopplungsspule nicht in Serie mit dem Wärmetauscher 14 der Detektionsspule angeordnet wird, sondern parallel dazu. Eine solche Anordnung ist in **Fig. 14** (hier im Vollausbau mit Temperaturmessung und Regelung aller Stufen, was aber nicht zwingend ist) dargestellt. Sie wird die gleichen wesentlichen erfindungsgemäßen Eigenschaften aufweisen wie die Ausführungsvariante 2. Auf eine genaue Analyse dieser Anordnung sei hier verzichtet. Es kann aber gesagt werden, dass diese ebenfalls mögliche Anordnung gegenüber der 2. Ausführungsvariante die folgenden abweichenden Eigenschaften aufweist:

  a) Für die Gesamtwärmebilanz gilt immer noch die gleiche Gleichung wie bei der 2. Ausführungsvariante. Insbesondere ist $T_F$ immer noch durch Eq. 1 b gegeben. Bei gleicher Belastung P1 und P2 wird $T_F$ immer noch gleich bleiben wie bei der Ausführungsvariante 2.
  b) Der Flow durch die beiden Wärmetauscher ist nicht mehr derselbe wie aus dem Kühler heraus in der Schlaufe 10. Es wird ein kontrolliertes Verzweigen des He-Stromes benötigt. Dazu kann u.U. ein Drosselventil 35 benötigt werden. Dieses kann sich wie dargestellt nach dem Wärmetauscher 14 befinden. Es sind aber auch andere Orte möglich und sinnvoll, wie z.B. nach dem Wärmetauscher 15, oder aber vor einem der Wärmetauscher.
  c) Der Wärmetauscher HX1 (14) der Detektionsspule bekommt zwar immer noch Gas mit der Temperatur $T_F$ hinein (gemäß Punkt a) oben), durch diesen Wärmetauscher fließt aber nicht mehr der volle He-Strom. Somit wird ($R_{Hx1}$ + $R_{He}$) höher als bei der Variante 2 sein, da $R_{He}$ wegen Eq. 7 bei sinkendem Massenfluss erhöht ist.
  d) Der Wärmetauscher HX2 (15) bekommt auch nicht mehr den vollen He-Strom mehr. Somit steigt auch ($R_{HX2}$ + $R_{He}$) etwas.
  e) Die Gesamteffizienz wird dadurch immer tiefer sein als bei der Variante 2. Dazu kommt noch, dass die Verteilung der Ströme von den zu erwartenden Leistungen abhängt und nicht mehr einfach ist. Der Vorteil dieser Anordnung liegt aber darin, dass bei einem eventuellen umgekehrten Betrieb (Entkopplung auf der ersten HF Spule 11 (und somit auf dem ersten Wärmetauscher HX1 (14), und Detektion auf der Spule 12), beide Temperaturen T1 und T2 immer noch unabhängig bleiben (Keine Auswirkung auf den Wärmetauscher 15 und die Temperatur der zweiten Spule 12, die nun als Empfangsspule dient.)

f) Bei der Variante 2 würde ein umgekehrter Betrieb gemäß Punkt e) trotzdem eine bessere Performance gegenüber dem Stand der Technik haben, da die Ineffizienz des HX1 (14) auf die Erwärmung des Gasstromes keinen Einfluss hat und sich die Empfangsspule 18 weniger erwärmt, wie wenn sie mit der Spule 11 von einem einzigen gemeinsamen Wärmetauscher 13 gekühlt würde. Eine darüber hinaus gehende Steigerung der Performance auf den Stand der Ausführungsvariante 2 würde hingegen eine Umkehr der Stromrichtung mit allen konstruktiven Konsequenzen bedingen, was technisch möglich, aber mit Aufwand verbunden ist.

## 4. Ausführungsvariante: Verallgemeinerung auf n Wärmetauscher:

Die Ausführungsvarianten 1-3 lassen sich auf eine beliebige Anzahl von n Wärmetauschern verallgemeinern. Insbesondere können z.B. 3 Wärmetauscher verwendet werden. Der dritte Wärmetauscher kann z.B. für einen zweiten Entkopplungskanal verwendet werden. Eine serielle Anordnung mit den Wärmetauschern 14 für die Detektionsspule sowie den Wärmetauschern 15 und 15b für die Entkopplungsspulen 12 und 12b ist in Fig. 15 dargestellt (hier im Vollausbau mit Temperaturmessung und Regelung aller Stufen, was aber nicht zwingend ist). Diese Anordnung hat den Vorteil, dass neben der Spule 11 auch mit der Spule 12 detektiert werden kann, ohne dass sich diese durch eine gleichzeitige Entkopplung auf der Spule 12b unmittelbar erwärmt.

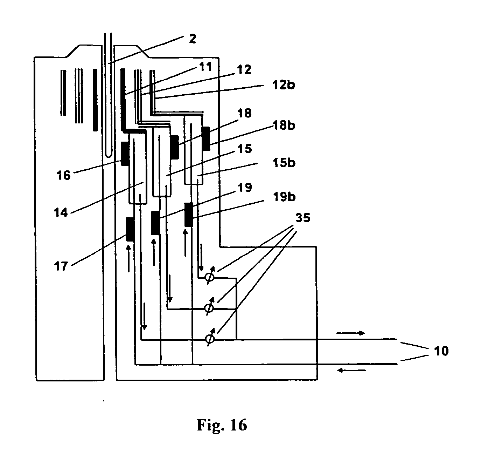

**Fig. 16** zeigt schließlich eine parallele Anordnung von drei Wärmetauschern 14, sowie 15 und 15b (auch hier im Vollausbau mit Temperaturmessung und Regelung aller Stufen, was aber nicht zwingend ist). Jeder der Kühlströme kann bei Bedarf durch ein Drosselventil 35 individuell eingestellt werden. Bei einer solchen Anordnung wird keine der HF Spulen 11, 12, oder 12b durch eine Entkopplung auf einer der anderen Spulen unmittelbar erwärmt. Die Erwärmung geschieht auch hier lediglich durch den Mittelwert {P}, der sich als Summe aller mittleren Leistungen und der Kennlinie des Coolers ergibt. Die Erwärmung der gerade nicht thermisch belasteten Spulen ergibt sich dann weiterhin gemäß Eq. 1 b und ist zeitlich langsam und im Wert minimal.

Es sind aber auch beliebige Kombinationen von Serie- und Parallelschaltungen möglich, deren Anordnung je nach den erwarteten Anwendungsarten bestimmt werden kann.

Die in den vier Ausführungsbeispielen erzielten günstigen Eigenschaften wurden mit einem aus gasförmigem He bestehenden Fluidum beschrieben und analysiert. Ein anderes Gas zum Wärmetransport ist aber auch möglich, wie auch die Verwendung eines Fluidums mit zwei Phasen. Das in den Kryokopf eintretende Fluidum kann flüssig oder ein Gemisch aus Flüssig- und Gasphase sein (insbesondere flüssig- /gasförmiges Helium). Die hier aufgeführten Betrachtungen können dann mit der zusätzlichen Energiebilanz der Verdampfungswärme durchgeführt werden. Solche Betrachtungen ergeben auch im Falle von Zweiphasen-Fluida direkte Vorteile gegenüber dem Stand der Technik in allen Fällen, wo das aus dem Kryokopf austretende Fluidum keine Flüssigphase mehr besitzt, da dann bei einer Anordnung gemäß dem Stand der Technik der Wärmetauscher 13 die spezifische Wärme der Gasphase nutzen muss, was prinzipiell mit einer Temperaturerhöhung verbunden ist und die minimale Temperatur der Detektionsspule hinaufsetzt. Bei einer erfindungsgemäßen Anordnung kann dieser Temperaturanstieg für die Detektionsspule vermieden werden. Aber auch in den Fällen, wo das austretende Fluidum immer einen Teil als Flüssigphase aufweist, ist eine Reduktion der Empfangsspulen-Temperatur sowie deren Schwankungen gegeben, denn die erfindungsgemäßen Anordnungen eliminieren die bei einer Anordnung gemäß dem Stand der Technik vorhandenen inneren Wärmewiderstände (Ineffizienz) des Wärmetauchers 13 und somit unerwünschte, zusätzliche Temperaturerhöhungen und Schwankungen der Detektionsspule als Folge der mittleren wie auch gepulsten Wärmelast.

Obwohl die obige Analyse mit einem geschlossenen Kühlkreislauf durchgeführt wurde, ist die vorliegende Erfindung auch bei der Verwendung einer offenen Kühlanordnung (z.B. LHe ab Fass) sinnvoll und vorteilhaft. Die Bezeichnung "Kühlschlaufe" kann sich sowohl auf einen offenen Kühlkreislauf wie auch auf eine offene Ein-Weg Anordnung beziehen.

Es ist weiterhin zu bemerken, dass bei der obigen Abhandlung die Sende/Entkopplungsspule sich auf einen anderen Kern bezog als die Detektionsspule. Es ist jedoch möglich und sinnvoll, diese Trennung auch bei einem Kern durchzuführen, indem dieser mit zwei Kanälen betrieben wird; der eine Kanal führt zur Detektionsspule, währenddem der andere Kanal zur Sendespule für den gleichen Kern geleitet wird. Somit kann die Sende- und Empfangsfunktion nicht nur zwischen zwei verschiedenen Kernen, sondern auch innerhalb desselben Kerns in zwei HF Spulen/Resonatoren aufgeteilt werden, der eine Kanal mit seiner HF Spule zur Detektion, der andere zum Senden/Entkoppeln. Eine solche Anordnung hat den Vorteil, dass prinzipiell gewisse oder alle Sendespulen auf z.B. den weiteren (zweiten) Wärmetauscher, und alle Detektionsspulen auf den ersten Wärmetauscher gesetzt werden können. Eine solche Anordnung dissipiert dann nur Wärme auf dem 2. Wärmetauscher, und der erste bleibt stets dissipationsfrei, und somit auf einer optimal kalten und stabilen Temperatur, unabhängig vom jeweiligen Betriebsmodus. In diesem Sinne bezieht sich der Begriff "Kanal" auf jeweils eine HF-Spule bzw. Resonator, völlig unabhängig davon, für welchen Kern dieser vorgesehen ist bzw. auf welcher Frequenz dieser betrieben wird.

Zusammenfassend kann man sagen, dass durch eine Trennung des Wärmetauschers im Kryokopf zur Kühlung der HF-Spulen in zwei oder mehrere verschiedene Wärmetauscher eine sehr deutliche Verbesserung der Eigenschaften eines Kryokopfes erzielt werden kann. Dies gilt in Bezug auf die Minimierung der absoluten Temperatur der Empfangsspule während des Betriebs, wie auch die praktisch vollständig eliminierten Temperaturschwankungen im für die Anwendungen typischen, gepulsten Betrieb. Die konstruktive Auslegung der Mehrfach-Wärmetauscher in typischerweise sehr beschränktem Platz eines Kryokopfes ist eine konstruktive Herausforderung, die jedoch mit bekannten Technologien und Verfahren gelöst werden kann. Der Aufwand für einen erfindungsgemäßen Kryokopf lohnt sich, denn es wird ein extrem effizientes und stabiles System erhalten.

**Liste der Bezeichnungen:**

| | |
|---|---|
| 1 | Kryokopf |
| 2 | Probe |
| 3 | Vakuum |
| 4 | Kalte Vorverstärker |
| 5 | Kühlsystem |
| 6 | Coldhead |
| 7 | Erste Stufe Coldhead |
| 8 | Zweite Stufe Coldhead |
| 9 | "Warme" Kühlschlaufe |
| 10 | "Kalte" Kühlschlaufe |
| 11 | Detektionsspule |
| 12 | Entkopplungsspule |
| 12b | Weitere Entkopplungsspule |
| 13 | Wärmetauscher für die HF Spulen (gemeinsam für Detektions- und Entkopplungsspule) |
| 14 | Wärmetauscher für Detektionsspule |
| 15 | Wärmetauscher für Entkopplungsspule |
| 16 | Temperatursensor Detektionsspule |
| 17 | Heizer Detektionsspule |
| 18 | Temperatursensor Entkopplungsspule |
| 18b | Temperatursensor von weiteren Entkopplungsspulen |
| 19 | Heizer Entkopplungsspule |
| 19b | Heizer von weiteren Entkopplungsspulen |
| 20 | Temperatursensor Vorverstärker |
| 21 | Heizer Vorverstärker |
| 22 | Zentralrohr |
| 23 | Bypass Kühlung Elektronik |
| 24 | Wärmetauscher allgemein |
| 25 | Idealer Wärmetauscher allgemein |
| 25b | Idealer Wärmetauscher als Teil des Wärmetauschers 14 |
| 25c | Idealer Wärmetauscher als Teil des Wärmetauschers 15 |
| 26 | Innerer Widerstand des Wärmetauschers allgemein |
| 26b | Innerer Widerstand des Wärmetauschers als Teil des Wärmetauschers 14 |
| 26b | Innerer Widerstand des Wärmetauschers als Teil des Wärmetauschers 15 |
| 27 | Zu kühlendes Objekt allgemein |
| 28 | Kühlmedium Eintritt in Wärmetauscher |
| 29 | Kühlmedium Austritt aus Wärmetauscher |
| 30 | Wärmeverlust (Temperaturzunahme im Vorwärtsfluss) |
| 31 | Wärmeverlust (Temperaturzunahme im Rückwärtsfluss) |
| 32 | Gegenstrom-Wärmetauscher im Kühler (Zwischen Raumtemperatur und erster Stufe) |
| 33 | Gegenstrom-Wärmetauscher im Kühler (Zwischen erster und zweiter Stufe) |
| 34. | Bypass der Vorverstärkerkühlung |
| 35 | Drosselventil zur Kontrolle des Kühlmittelflusses bei paralleler Anordnung der Wärmetauscher |
| 36 | Temperatursensor für die HF Spulen |
| 37 | Heizer für die HF Spulen |
| 38 | Stufen-Wärmetauscher der ersten Coldheadstufe |

| 39 | Stufen-Wärmetauscher der zweiten Coldheadstufe |
|---|---|
| 40 | Transferline |
| 41 | Anschlüsse für Zirkulationspumpe (Kompressor) bei Raumtemperatur |
| 42 | Cooler Kennlinie, beschrieben durch äquivalenten Wärmewiderstand |
| 43 | Innerer Widerstand des Cooler-Wärmetauschers |
| 44 | Idealer Wärmetauscher am Cooler (2. Stufe) |
| 45-49 | Nicht verwendet |
| 50 | Entkopplungspuls |
| 51 | Pause zwischen Entkopplungen |
| 52 | Repetitionsperiode des Experiments |
| 53 | Mittlere Entkopplungsleistung |
| 54a | Zeitlicher Temperaturverlauf am Wärmetauscher, bei langer thermischer Zeitkonstante |
| 54b | Zeitlicher Temperaturverlauf am Wärmetauscher, bei kurzer thermischer Zeitkonstante |
| 55 | Mittlere Temperatur am Wärmetauscher |
| 56 | Asymptotische Maximaltemperatur am Wärmetauscher |
| 57 | Minimale Temperatur am Wärmetauscher |
| 58 | Temperatur der Detektionsspule |

**Verzeichnis der verwendeten Abkürzungen**

| $P_D(t)$ | Zeitabhängige Entkopplungsleistung |
|---|---|
| $\{P_D\}$ | Mittlere Entkopplungsleistung (Zeitmittel) |
| $T_{Ave}$ | Mittlere Temperatur der .... Spulen (je nach Kontext) |
| $T_{Asy}$ | Asymptotische Temperatur, die während der Entkopplung erreicht werden kann |
| C | Spezifische Wärme der Spulenbaugruppe (Wärmetauscher 13 sowie die Spulen 11 und 12) |
| $T_{Dyn}(1)$ | Dynamischer Temperaturverlauf bei hohem C |
| $T_{Dyn}(2)$ | Dynamischer Temperaturverlauf bei niedrigem C |
| T1 | Temperatur des Detektionswärmetauschers |
| T2 | Temperatur des Entkopplungswärmetauschers |
| $T_F$ | Austrittstemperatur des kalten Kühlschlaufe 10 (Forward) aus dem Kühlsystem |
| $T_{CHintr}$ | Die intrinsische (minimale) Temperatur der zweiten Stufe des Coldheads, ohne Wärmebelastung aus der dissipierten HF Leistung |
| HX | Wärmetauscher im Kryokopf zur Kühlung beider HF Spulen |
| $HX_{in}$ | In den Wärmetauscher eintretendes He |
| $HX_{out}$ | Aus dem Wärmetauscher austretendes He |
| P | Wärmelast des abzukühlenden Objekts |
| $T_{load}$ | Temperatur der Wärmelast (des abzukühlenden Objekts) |
| $dT_{flow}$ | Erwärmung des Gasstromes |
| $dT_{load}$ | Erwärmung der Wärmelast gegenüber der Temperatur des eintretendes Gasstromes |
| dm/dt | Massenfluss des Gases pro Zeiteinheit |
| Cp | Spezifische Wärme des Gases |
| $R_{HX}$ | Innerer Wärmewiderstand eines Wärmetauschers zur Beschreibung seiner Ineffizienz |
| $T_c.$ | Temperatur der HF Spulen (beide Detektions- und Entkopplungsspule gemeinsam) |
| $P_{peak}$ | Peakleistung (Spitzenleistung) während Entkopplung |
| $T_{cpeak}$ | Peak-Temperatur der Spulen |
| HX1 | Wärmetauscher (14) der Detektionsspule (11) |
| HX2 | Wärmetauscher (15) der Entkopplungsspule (12) |
| P1 | Wärmeintrag der Detektionsspule |
| P2 | Wärmeintrag der Entkopplungsspule |
| $\Delta$T1 | = $\Delta T_{Det}$ : Temperaturzunahme der Detektionsspule |
| $\Delta$T2 | = $\Delta T_{Dec}$: Temperaturzunahme der Entkopplungsspule |
| $R_{HX1}$ | Innerer Wärmewiderstand des Wärmetauschers HX1 |
| $R_{HX2}$ | Innerer Wärmewiderstand des Wärmetauschers HX2 |

**Patentansprüche**

1.  Kryokopf (1) für Kernspinresonanz(=NMR)-Messungen,
    mit mindestens einem Detektionskanal zum Empfang von NMR-Signalen und mit mindestens einem Sende- oder Entkopplungskanal,
    wobei für die verschiedenen Kanäle verschiedene Hochfrequenz(=HF)-Spulen oder Resonatoren (11, 12, 12b) vorgesehen sind,
    wobei der Kryokopf (1) einen Wärmetauscher aufweist, der durch ein durchströmendes Fluidum, insbesondere Helium, kühlbar ist,
    und wobei die HF-Spulen oder Resonatoren (11, 12, 12b) sowohl mindestens eines Detektionskanals als auch mindestens eines Sende- oder Entkopplungskanals auf kryogene Temperaturen kühlbar sind,
    **dadurch gekennzeichnet, dass**
    mindestens zwei Wärmetauscher (14, 15) vorgesehen sind, wobei mindestens ein erster Wärmetauscher (14) die HF-Spule oder den Resonator (11) des mindestens einen Detektionskanals und mindestens ein weiterer Wärmetauscher (15) die HF-Spule oder den Resonator (12, 12b) des mindestens einen Sende- oder Entkopplungskanals kühlt, und wobei der mindestens eine erste Wärmetauscher (14) von dem mindestens einen weiteren Wärmetauscher (15) getrennt ist.

2.  Kryokopf (1) nach Anspruch 1, **dadurch gekennzeichnet, dass** der oder die Wärmetauscher (14) des mindestens einen Detektionskanals durch eine separate Kühlschlaufe (10) des Fluidums kühlbar sind, die von einer Kühlschlaufe (9) des einen oder der mehreren Wärmetauscher (15) des mindestens einen Sende- oder Entkopplungskanals getrennt ist.

3.  Kryokopf (1) nach Anspruch 1, **dadurch gekennzeichnet, dass** der oder die Wärmetauscher (14) des mindestens einen Detektionskanals und der oder die Wärmetauscher (15) des mindestens einen Sende- oder Entkopplungskanals mit einer gemeinsamen Kühlschlaufe (10) des Fluidums kühlbar sind.

4.  Kryokopf (1) nach Anspruch 3, **dadurch gekennzeichnet, dass** der oder die Wärmetauscher (14) des mindestens einen Detektionskanals und der oder die Wärmetauscher (15) des mindestens einen Sende- oder Entkopplungskanals mit zwei in parallel verzweigten Pfaden der gemeinsamen Kühlschlaufe (10) des Fluidums kühlbar sind.

5.  Kryokopf (1) nach Anspruch 3, **dadurch gekennzeichnet, dass** der oder die Wärmetauscher (14) des mindestens einen Detektionskanals und der oder die Wärmetauscher (15) des mindestens einen Sende- oder Entkopplungskanals mit in Serie verlaufenden Pfaden der gemeinsamen Kühlschlaufe (10) des Fluidums kühlbar sind.

6.  Kryokopf (1) nach Anspruch 5, **dadurch gekennzeichnet, dass** der oder die Wärmetauscher (14) des mindestens einen Detektionskanals vom Fluidum zuerst, und der oder die Wärmetauscher (15) des mindestens einen Sende- oder Entkopplungskanals danach durchflossen werden.

7.  Kryokopf (1) nach Anspruch 3, **dadurch gekennzeichnet, dass** der oder die Wärmetauscher (14) des mindestens einen Detektionskanals und der oder die Wärmetauscher (15) des mindestens einen Sende- oder Entkopplungskanals mit mehr als zwei in parallel verlaufenden Pfaden der gemeinsamen Kühlschlaufe (10) des Fluidums kühlbar sind.

8.  Kryokopf (1) nach Anspruch 3, **dadurch gekennzeichnet, dass** der oder die Wärmetauscher (14) des mindestens einen Detektionskanals und der oder die Wärmetauscher (15) des mindestens einen Sende- oder Entkopplungskanals mit mehr als zwei in Serie verlaufenden Pfaden der gemeinsamen Kühlschlaufe (10) des Fluidums kühlbar sind.

9.  Kryokopf (1) nach Anspruch 8, **dadurch gekennzeichnet, dass** der oder die Wärmetauscher (14) des mindestens einen Detektionskanals vom Fluidum zuerst, und der oder die Wärmetauscher (15) des mindestens einen Sende- oder Entkopplungskanals danach durchflossen werden.

10. Kryokopf (1) nach Anspruch 3, **dadurch gekennzeichnet, dass** der oder die Wärmetauscher (14) des mindestens einen Detektionskanals und der oder die Wärmetauscher (15) des mindestens einen Sende- oder Entkopplungskanals in einer Kombination von Parallel- und Serienschaltung von Pfaden der gemeinsamen Kühlschlaufe des Fluidums durchflossen werden.

**11.** Kryokopf (1) nach einem der vorhergehenden Ansprüche, **dadurch gekennzeichnet, dass** genau ein erster Wärmetauscher (14) vorgesehen ist, der die HF-Spulen oder Resonatoren (11) aller Detektionskanäle kühlt, insbesondere wobei mehrere Detektionskanäle vorgesehen sind.

**12.** Kryokopf (1) nach einem der vorhergehenden Ansprüche, **dadurch gekennzeichnet, dass** genau ein weiterer Wärmetauscher (15) vorgesehen ist, der die HF-Spulen oder Resonatoren (12, 12b) aller Sende- oder Entkopplungskanäle kühlt, insbesondere wobei mehrere Sende- oder Entkopplungskanäle vorgesehen sind.

**Claims**

**1.** Cryohead (1) for nuclear magnetic resonance (NMR) measurements, comprising at least one detection channel for receiving NMR signals and at least one transmitting or decoupling channel, wherein different radio frequency (RF) coils or resonators (11, 12, 12b) are provided for the different channels, wherein the cryohead (1) comprises a heat exchanger which can be cooled by a flow-through fluid, in particular helium, and wherein the RF coils or resonators (11, 12, 12b) of at least one detection channel and also at least one transmitting or decoupling channel can be cooled to cryogenic temperatures, **characterized in that** at least two heat exchangers (14, 15) are provided, wherein at least one first heat exchanger (14) cools the RF coil or the resonator (11) of the at least one detection channel and at least one further heat exchanger (15) cools the RF coil or the resonator (12, 12b) of the at least one transmitting or decoupling channel, and wherein the at least one first heat exchanger (14) is separated from the at least one further heat exchanger (15).

**2.** Cryohead (1) according to claim 1, **characterized in that** the heat exchanger(s) (14) of the at least one detection channel can be cooled by a separate fluid cooling loop (10), which is separated from a cooling loop (9) of the one or more heat exchanger(s) (15) of the at least one transmitting or decoupling channel.

**3.** Cryohead (1) according to claim 1, **characterized in that** the heat exchanger(s) (14) of the at least one detection channel and the heat exchanger(s) (15) of the at least one transmitting or decoupling channel can be cooled with a common fluid cooling loop (10).

**4.** Cryohead (1) according to claim 3, **characterized in that** the heat exchanger(s) (14) of the at least one detection channel and the heat exchanger(s) (15) of the at least one transmitting or decoupling channel can be cooled with two parallel branched paths of the common fluid cooling loop (10).

**5.** Cryohead (1) according to claim 3, **characterized in that** the heat exchanger(s) (14) of the at least one detection channel and the heat exchanger(s) (15) of the at least one transmitting or decoupling channel can be cooled with paths of the common fluid cooling loop (10), which are disposed in series.

**6.** Cryohead (1) according to claim 5, **characterized in that** the heat exchanger(s) (14) of the at least one detection channel is/are first passed by the fluid and the heat exchanger(s) (15) of the at least one transmitting or decoupling channel are passed subsequent thereto.

**7.** Cryohead (1) according to claim 3, **characterized in that** the heat exchanger(s) (14) of the at least one detection channel and the heat exchanger(s) (15) of the at least one transmitting or decoupling channel can be cooled with more than two parallel paths of the common fluid cooling loop (10).

**8.** Cryohead (1) according to claim 3, **characterized in that** the heat exchanger(s) (14) of the at least one detection channel and the heat exchanger(s) (15) of the at least one transmitting or decoupling channel can be cooled with more than two paths of the common fluid cooling loop (10), which are disposed in series.

**9.** Cryohead (1) according to claim 8, **characterized in that** the fluid first passes through the heat exchanger(s) (14) of the at least one detection channel and then through the heat exchanger(s) (15) of the at least one transmitting or decoupling channel.

**10.** Cryohead (1) according to claim 3, **characterized in that** the common fluid cooling loop passes through the heat exchanger(s) (14) of the at least one detection channel and the heat exchanger(s) (15) of the at least one transmitting or decoupling channel in a combination of paths, extending parallel and in series.

**11.** Cryohead (1) according to any one of the preceding claims, **characterized in that** exactly one first heat exchanger (14) is provided which cools the RF coils or resonators (11) of all detection channels, in particular, wherein several detection channels are provided.

**12.** Cryohead (1) according to any one of the preceding claims, **characterized in that** exactly one further heat exchanger (15) is provided which cools the RF coils or resonators (12, 12b) of all transmitting or decoupling channels, in particular, wherein several transmitting or decoupling channels are provided.

**Revendications**

**1.** Tête cryogénique (1) pour des mesures de résonance magnétique nucléaire (= RMN),
avec au moins un canal de détection pour la réception de signaux RMN et avec au moins un canal d'émission ou de découplage, différentes bobines haute fréquence (= HF) ou résonateurs (11, 12, 12b) étant prévus pour les différents canaux,
la tête cryogénique (1) présentant un échangeur thermique qui peut être refroidi par un fluide qui le traverse, en particulier de l'hélium,
et les bobines HF ou résonateurs (11, 12, 12b) aussi bien au moins d'un canal de détection qu'au moins d'un canal d'émission ou de découplage pouvant être refroidis à des températures cryogéniques,
**caractérisée en ce que**
il est prévu au moins deux échangeurs thermiques (14, 15), au moins un premier échangeur thermique (14) refroidissant la bobine HF ou le résonateur (11) dudit au moins un canal de détection et au moins un autre échangeur thermique (15) la bobine HF ou le résonateur (12, 12b) dudit au moins un canal d'émission ou de découplage, et ledit au moins un premier échangeur thermique (14) étant séparé dudit au moins un autre échangeur thermique (15).

**2.** Tête cryogénique (1) selon la revendication 1, **caractérisée en ce que** le ou les échangeur(s) thermique(s) (14) dudit au moins un canal de détection peut ou peuvent être refroidi(s) par une boucle de refroidissement séparée (10) du fluide, qui est séparée d'une boucle de refroidissement (9) du ou des échangeur(s) thermique(s) (15) dudit au moins un canal d'émission ou de découplage.

**3.** Tête cryogénique (1) selon la revendication 1, **caractérisée en ce que** le ou les échangeur(s) thermique(s) (14) dudit au moins un canal de détection et le ou les échangeur(s) thermique(s) (15) dudit au moins un canal d'émission ou de découplage peuvent être refroidis par une boucle de refroidissement commune (10) du fluide.

**4.** Tête cryogénique (1) selon la revendication 3, **caractérisée en ce que** le ou les échangeur(s) thermique(s) (14) dudit au moins un canal de détection et le ou les échangeur(s) thermique(s) (15) dudit au moins un canal d'émission ou de découplage peuvent être refroidis par deux chemins ramifiés en parallèle de la boucle de refroidissement commune (10) du fluide.

**5.** Tête cryogénique (1) selon la revendication 3, **caractérisée en ce que** le ou les échangeur(s) thermique(s) (14) dudit au moins un canal de détection et le ou les échangeur(s) thermique(s) (15) dudit au moins un canal d'émission ou de découplage peuvent être refroidis par des chemins s'étendant en série de la boucle de refroidissement commune (10) du fluide.

**6.** Tête cryogénique (1) selon la revendication 5, **caractérisée en ce que** le ou les échangeur(s) thermique(s) (14) dudit au moins un canal de détection est ou sont traversé(s) par le fluide en premier lieu et le ou les échangeur(s) thermique(s) (15) dudit au moins un canal d'émission ou de découplage en second lieu.

**7.** Tête cryogénique (1) selon la revendication 3, **caractérisée en ce que** le ou les échangeur(s) thermique(s) (14) dudit au moins un canal de détection et le ou les échangeur(s) thermique(s) (15) dudit au moins un canal d'émission ou de découplage peuvent être refroidis par plus de deux chemins s'étendant en parallèle de la boucle de refroidissement commune (10) du fluide.

**8.** Tête cryogénique (1) selon la revendication 3, **caractérisée en ce que** le ou les échangeur(s) thermique(s) (14) dudit au moins un canal de détection et le ou les échangeur(s) thermique(s) (15) dudit au moins un canal d'émission ou de découplage peuvent être refroidis par plus de deux chemins s'étendant en série de la boucle de refroidissement commune (10) du fluide.

**9.** Tête cryogénique (1) selon la revendication 8, **caractérisée en ce que** le ou les échangeur(s) thermique(s) (14) dudit au moins un canal de détection est ou sont traversé(s) par le fluide en premier lieu et le ou les échangeur(s) thermique(s) (15) dudit au moins un canal d'émission ou de découplage en second lieu.

**10.** Tête cryogénique (1) selon la revendication 3, **caractérisée en ce que** le ou les échangeur(s) thermique(s) (14) dudit au moins un canal de détection et le ou les échangeur(s) thermique(s) (15) dudit au moins un canal d'émission ou de découplage sont traversés par une combinaison de couplages en parallèle et en série de chemins de la boucle de refroidissement commune du fluide.

**11.** Tête cryogénique (1) selon une des revendications précédentes, **caractérisée en ce qu'**il est prévu exactement un premier échangeur thermique (14) qui refroidit les bobines HF ou résonateurs (11) de tous les canaux de détection, plusieurs canaux de détection étant en particulier prévus.

**12.** Tête cryogénique (1) selon une des revendications précédentes, **caractérisée en ce qu'**il est prévu exactement un autre échangeur thermique (15) qui refroidit les bobines HF ou résonateurs (12, 12b) de tous les canaux d'émission ou de découplage, plusieurs d'émission ou de découplage étant en particulier prévus.

**Fig. 1**

**Fig.2**

$P_D(t)$

50

53

0

{$P_D$}

t

51

52

**Fig. 3**

2

11

12

36

13

37

4

9

10

**Fig. 4**

Fig. 5

Fig. 6

Fig. 7

Fig. 8

Fig. 9

**Fig. 10**

**Fig. 11**

Fig. 12

Fig. 13

**Fig. 14**

**Fig. 15**

**Fig. 16**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5889456 A